# EUROPEAN PATENT APPLICATION

(11) **EP 4 579 640 A1**
(43) Date of publication of application: **02.07.2025**
(21) Application number: 24187593.9
(22) Date of filing: 10.07.2024
(51) Int. Cl.: G09G 3/32

(54) **DISPLAY DEVICE**

(30) Priority: 27.12.2023 KR 20230193506
(71) Applicant: LG Display Co., Ltd., Seoul 07336 (KR)
(72) Inventor: SONG, SangMoo, 10845 Paju-si, Gyeonggi-do (KR)
(74) Representative: Viering, Jentschura & Partner mbB Patent- und Rechtsanwälte

(57) **Abstract**

Disclosed is a display device (100). The display device (100) includes a display panel (PN) divided into a first area (A1) including a plurality of first pixels (PX1) and a plurality of second pixels (PX2), and a second area (A2) including a plurality of third pixels (PX3) adjacent to the first area (A1) in a direction opposite to a first direction (DR1), wherein each of the plurality of first pixels (PX1) includes a first light emitting diode (ED1), a second light emitting diode (ED2), a first optical member which emits light generated from the first light emitting diode (ED1) at a first viewing angle, and a second optical member which emits light generated from the second light emitting diode (ED2) at the first viewing angle, and each of the plurality of second pixels (PX2) includes a third light emitting diode (ED3), a fourth light emitting diode (ED4), a third optical member which emits light generated from the third light emitting diode (ED3) at the first viewing angle, and a fourth optical member which emits light generated from the fourth light emitting diode (ED4) at a second viewing angle lower than the first viewing angle, and each of the plurality of third pixels (PX3) includes a fifth light emitting diode (ED5), a sixth light emitting diode (ED6), a fifth optical member which emits light generated from the fifth light emitting diode (ED5) at the first viewing angle, and a sixth optical member which emits light generated from the sixth light emitting diode (ED6) at the second viewing angle.

## Description

### BACKGROUND

### Technical Field

The present disclosure relates to a display device, and more particularly, for example, without limitation, to a display device whose viewing angle can be controlled.

### Description of the Related Art

With the advancement of technologies in the modern society, a display device has been used in various forms to supply users with information. The display device includes a liquid crystal display device (LCD), a plasma display device (PDP), a field emission display device (FED), an organic light-emitting display device (OLED), and a micro LED (Micro Light Emitting Diode) display device, etc. The display device is also included in various electronic devices, which receive a user input and use advanced technologies to supply information in response to the received input, as well as an electronic display board that unilaterally transfers visual information.

For example, the display device may be included in a vehicle to supply various kinds of information to a driver and a passenger of the vehicle. However, the display device of the vehicle needs to properly display content so as not to disturb driving of the vehicle. For example, the display device needs to limit a display of content which can potentially disturb the driver's concentration on driving during the driving of the vehicle.

The description provided in the discussion of the related art section should not be assumed to be prior art merely because it is mentioned in or associated with that section. The discussion of the related art section may include information that describes one or more aspects of the subject technology, and the description in this section does not limit the invention.

### SUMMARY

Therefore, the inventors of the present disclosure recognized the limitations or problems mentioned above and other limitations associated with the related art, and conducted various experiments to implement a display device whose viewing angle can be controlled.

An object to be achieved by the present disclosure is to provide a display device which can reduce or minimize visibility of a boundary between a first area which supplies content at a wide viewing angle and a second area which supplies content at a wide viewing angle or a narrow viewing angle.

Another obj ect to be achieved by the present disclosure is to provide a display device which can reduce or minimize power consumption caused by an increase in luminance.

Objects of the present disclosure are not limited to the above-mentioned obj ects, and other objects, which are not mentioned above, can be clearly understood by those skilled in the art from the following descriptions.

Various embodiments provide a display device according to claim 1. Further embodiments are described in the dependent claims. A display device according to an exemplary embodiment of the present disclosure includes a display panel divided into a first area including a plurality of first pixels and a plurality of second pixels, and a second area including a plurality of third pixels adjacent to the first area in a direction opposite to a first direction, wherein each of the plurality of first pixels includes a first light emitting diode, a second light emitting diode, a first optical member which emits light generated from the first light emitting diode at a first viewing angle, and a second optical member which emits light generated from the second light emitting diode at the first viewing angle, and each of the plurality of second pixels includes a third light emitting diode, a fourth light emitting diode, a third optical member which emits light generated from the third light emitting diode at the first viewing angle, and a fourth optical member which emits light generated from the fourth light emitting diode at a second viewing angle lower than the first viewing angle, and each of the plurality of third pixels includes a fifth light emitting diode, a sixth light emitting diode, a fifth optical member which emits light generated from the fifth light emitting diode at the first viewing angle, and a sixth optical member which emits light generated from the sixth light emitting diode at the second viewing angle. Further, the plurality of second pixels is disposed at different pixel densities in respective regions of the first area.

Other detailed matters of the exemplary embodiments are included in the detailed description and the drawings.

According to an exemplary embodiment of the present disclosure, it is possible to display content at a wide viewing angle in a first area of a display panel. Also, it is possible to display content at a wide viewing angle or a narrow viewing angle in a second area.

According to an exemplary embodiment of the present disclosure, a pixel having the same lens structure as a pixel disposed in the second area is further disposed in the first area. Thus, it is possible to minimize visibility of a boundary between the first area and the second area.

According to an exemplary embodiment of the present disclosure, the first area is driven to allow all of a plurality of light emitting diodes included in a plurality of pixels, respectively, to emit light. The plurality of pixels is disposed in the first area which supplies content at a wide viewing angle. Thus, when content is supplied at a wide viewing angle and the same data signal is written at the same time, a luminance can be increased.

According to an exemplary embodiment of the present disclosure, it is possible to reduce or minimize power consumption for increasing a luminance.

The effects according to the present disclosure are not limited to the contents exemplified above, and more various effects are included in the present disclosure.

It is to be understood that both the foregoing general description and the following detailed description of the present disclosure are exemplary and explanatory and are intended to provide further explanation of the inventive concepts as claimed.

### BRIEF DESCRIPTION OF DRAWINGS

The above and other aspects, features and other advantages of the present disclosure will be more clearly understood from the following detailed description taken in conjunction with the accompanying drawings, in which:
FIG. 1 illustrates an example of a display device according to an exemplary embodiment of the present disclosure;
FIG. 2 is a functional block view illustrating the display device according to an exemplary embodiment of the present disclosure;
FIG. 3 is a circuit diagram illustrating an example of a pixel circuit of the display device according to an exemplary embodiment of the present disclosure;
FIG. 4 is a circuit diagram illustrating an example of a pixel circuit of the display device according to an exemplary embodiment of the present disclosure;
FIG. 5A and FIG. 5B are waveform diagrams for explaining the pixel circuit of FIG. 4;
FIG. 6 and FIG. 7 are cross-sectional views of the display device according to an exemplary embodiment of the present disclosure;
FIG. 8 is a circuit diagram illustrating an example of a first pixel of the display device according to an exemplary embodiment of the present disclosure;
FIG. 9 is a circuit diagram illustrating an example of a second pixel of the display device according to an exemplary embodiment of the present disclosure;
FIG. 10 is a circuit diagram illustrating an example of a third pixel of the display device according to an exemplary embodiment of the present disclosure;
FIG. 11 illustrates an example of a display panel of the display device according to an exemplary embodiment of the present disclosure;
FIG. 12 illustrates an example of a first area of the display panel of FIG. 11;
FIG. 13A illustrates an example where the display device according to an exemplary embodiment of the present disclosure is driven in a first mode;
FIG. 13B illustrates an example where the display device according to an exemplary embodiment of the present disclosure is driven in a second mode;
FIG. 14 illustrates an example where the first area of FIG. 12 is driven;
FIG. 15 illustrates another example where the first area of FIG. 12 is driven;
FIG. 16 illustrates another example of a first area of the display panel of FIG. 11;
FIG. 17 illustrates yet another example of a first area of the display panel of FIG. 11; and
FIG. 18 illustrates still another example of a first area of the display panel of FIG. 11.

Throughout the drawings and the detailed description, unless otherwise described, the same drawing reference numerals should be understood to refer to the same elements, features, and structures. The relative size and depiction of these elements may be exaggerated for clarity, illustration, and convenience.

### DETAILED DESCRIPTION OF THE EMBODIMENT

Reference will now be made in detail to embodiments of the present disclosure, examples of which may be illustrated in the accompanying drawings. The progression of processing steps and/or operations described is an example; however, the sequence of steps and/or operations is not limited to that set forth herein and may be changed as is known in the art, with the exception of steps and/or operations necessarily occurring in a particular order. Names of the respective elements used in the following explanations may be selected only for convenience of writing the specification and may be thus different from those used in actual products.

Advantages and characteristics of the present disclosure and a method of achieving the advantages and characteristics will be clear by referring to exemplary embodiments described below in detail together with the accompanying drawings. However, the present disclosure is not limited to the exemplary embodiments disclosed herein but will be implemented in various forms. The exemplary embodiments are provided by way of example only so that those skilled in the art can fully understand the disclosures of the present disclosure and the scope of the present disclosure. Therefore, the present disclosure will be defined only by the scope of the appended claims.

The shapes, sizes, ratios, angles, numbers, and the like illustrated in the accompanying drawings for describing the exemplary embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as "including," "having," and "consist of" used herein are generally intended to allow other components to be added unless the terms are used with the term "only". Any references to singular may include plural unless expressly stated otherwise. Any implementation described herein as an "example" is not necessarily to be construed as preferred or advantageous over other implementations.

In describing a position relationship, when a position relation between two parts is described as, for example, "on," "over," "under," or "next," one or more other parts may be disposed between the two parts unless a more limiting term, such as "just" or "direct(ly)," is used. In describing a time relationship, for example, when the temporal order is described as, "after," "subsequent," "next," or "before," a case that is not continuous may be included, unless a more limiting term, such as "just," "immediate(ly)," or "direct(ly)," is used..

In descriptions of temporal relationships, for example, temporal precedent relationships between two events such as "after", "subsequent to", "before", etc., another event may occur therebetween unless "directly after", "directly subsequent" or "directly before" is not indicated.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

Where an element or layer is referred to as being "on" or "connected to" another element or layer, it should be understood to mean that the element or layer may be directly on or directly connected to the other element or layer, or that intervening elements or layers may be present. Also, where one element is referred to as being disposed "on" or "under" another element, it should be understood to mean that elements may be so disposed to directly contact each other, or may be so disposed without directly contacting each other.

The expression of a first element, a second elements "and/or" a third element should be understood as one of the first, second and third elements or as any or all combinations of the first, second and third elements. By way of example, A, B and/or C can refer to only A; only B; only C; any or some combination of A, B, and C; or all of A, B, and C.

The features of various exemplary embodiments of the present disclosure can be partially or entirely adhered to or combined with each other and can be interlocked and operated in technically various ways, and the embodiments can be carried out independently of or in association with each other.

The term "at least one" should be understood as including any and all combinations of one or more of the associated listed items. For example, the meaning of "at least one of a first element, a second element, and a third element" compasses the combination of all three listed elements, combinations of any two of the three elements, as well as each individual element, the first element, the second element, or the third element.

In the description of embodiments, when a structure is described as being positioned "on or above" or "under or below" another structure, this description should be construed as including a case in which the structures contact each other as well as a case in which a third structure is disposed therebetween. The size and thickness of each element shown in the drawings may be given merely for the convenience of description, and embodiments of the present disclosure may not be limited thereto.

Features of various embodiments of the present disclosure may be partially or overall coupled to or combined with each other, and may be variously inter-operated with each other and driven technically as those skilled in the art can sufficiently understand. Embodiments of the present disclosure may be carried out independently from each other, or may be carried out together in co-dependent relationship.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning for example consistent with their meaning in the context of the relevant art and should not be interpreted in an idealized or overly formal sense unless expressly so defined herein. For example, the term "part" or "unit" may apply, for example, to a separate circuit or structure, an integrated circuit, a computational block of a circuit device, or any structure configured to perform a described function as should be understood to one of ordinary skill in the art.

In addition, when any dimensions, relative sizes etc. are mentioned, it should be considered that numerical values for an elements or features, or corresponding information (e.g., level, range, etc.) include a tolerance or error range that may be caused by various factors (e.g., process factors, internal or external impact, noise, etc.) even when a relevant description is not specified. Further, the term "may" fully encompasses all the meanings of the term "can".

Hereinafter, example embodiments of the present disclosure will be described in detail with reference to the accompanying drawings. For convenience of description, a scale of each of elements illustrated in the accompanying drawings differs from a real scale, and thus, is not limited to a scale illustrated in the drawings.

Hereinafter, exemplary embodiments of the present disclosure will be described in detail with reference to accompanying drawings.

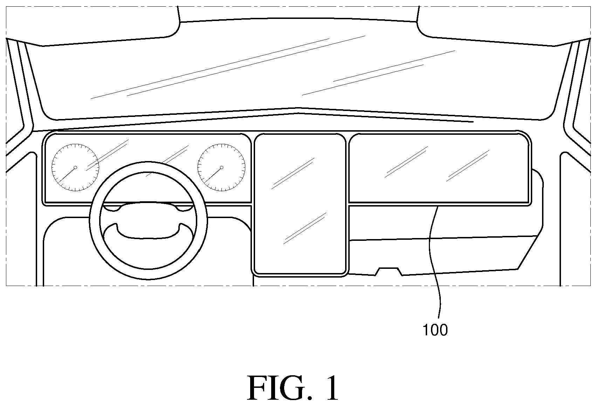

FIG. 1 illustrates an example of a display device according to an exemplary embodiment of the present disclosure.

Referring to FIG. 1, a display device 100 may be disposed on at least a portion of a dashboard of a vehicle. The dashboard of the vehicle may include components disposed on a front surface of a front seat (e.g., driver seat, passenger seat) in the vehicle. For example, input components for manipulating various functions (e.g., air conditioner, audio system, navigation system) inside the vehicle may be disposed on the dashboard of the vehicle.

The display device 100 may be disposed on the dashboard of the vehicle and may operate as an input unit for manipulating at least some of the various functions of the vehicle. The display device 100 may supply various kinds of information related to the vehicle, for example, driving information of the vehicle (e.g., present speed, residual fuel quantity, mileage), and information related to components of the vehicle (e.g., damage degree of a vehicle tire).

The display device 100 may be disposed to extend across the driver seat and the front passenger seat, which are front seats in the vehicle. A user of the display device 100 may include a driver of the vehicle and a passenger on the front passenger seat in the vehicle. Both of the driver and the passenger may use the display device 100.

FIG. 1 may show a portion of the display device 100. FIG. 1 may show a display panel among various components of the display device 100. Specifically, for example, the display device 100 shown in FIG. 1 may represent at least a portion of a display area and a non-display area of the display panel. The other components of the display device 100 may be mounted in the interior (or at least a portion) of the vehicle.

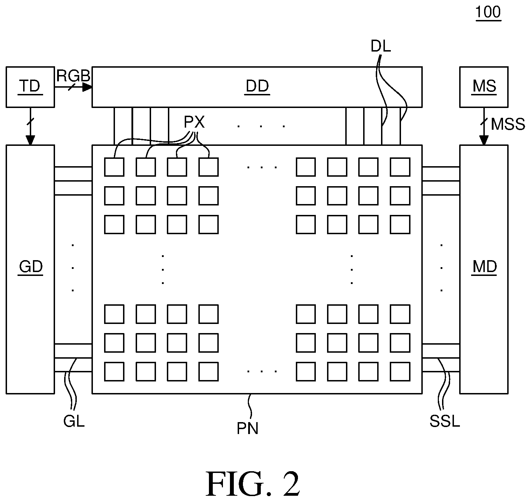

FIG. 2 is a functional block view illustrating the display device according to an exemplary embodiment of the present disclosure.

An electroluminescent display device may be applied to the display device according to an exemplary embodiment of the present disclosure. The electroluminescent display device may be an organic light emitting diode display device, a quantum-dot light emitting diode display device, or an inorganic light emitting diode display device, without being limited thereto.

Referring to FIG. 2, the display device 100 may include a display panel PN, a data driver DD, a gate driver GD, and a timing controller TD, without being limited thereto. The display device 100 may further include a mode controller MS and a mode selection unit MD.

The display panel PN may generate an image to be supplied to the user. For example, the display panel PN may generate and display an image to be supplied to the user through a plurality of pixels PX including a plurality of pixel circuits, respectively.

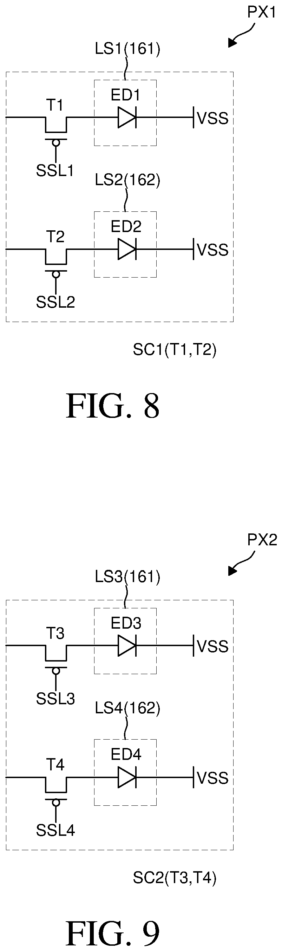

The plurality of pixels PX may include a first pixel, a second pixel, a third pixel, and the like disposed in each area of the display panel PN, without being limited thereto. Details of the first pixel, the second pixel, the third pixel, and a disposition relationship thereof will be described below with reference to FIG. 8 through FIG. 12.

The data driver DD, the gate driver GD, and the timing controller TD may supply a signal for operating pixels PX through signal lines, respectively. For example, the signal lines for supplying a signal for operating pixels PX may include a plurality of data lines DL and a plurality of gate lines GL, without being limited thereto. As an example, one or more additional signal lines (such as an emitting control line, a sensing line, etc.) could be further included.

The mode selection unit MD may supply a signal for controlling a driving mode of pixels PX through the signal lines, respectively. For example, the signal lines for supplying a signal for controlling a driving mode of pixels PX may include a plurality of selection signal lines SSL.

The plurality of data lines DL may be disposed in a column direction, and may include a plurality of lines connected to pixels PX disposed in one column direction. Also, the plurality of gate lines GL is disposed in a row direction, and may include a plurality of lines connected to pixels PX disposed in one row direction. However, the arrangement of the plurality of data lines DL and the plurality of gate lines GL is not limited thereto.

Also, the plurality of selection signal lines SSL is disposed in the row direction, and may include a plurality of lines connected to pixels PX disposed in one row direction, without being limited thereto.

The plurality of selection signal lines SSL may include a plurality of selection signal lines, for example first to sixth selection signal lines, but is not limited thereto. Herein, the first and second selection signal lines are commonly connected to the first pixel included in the plurality of pixels PX. Further, the third and fourth selection signal lines are commonly connected to the second pixel included in the plurality of pixels PX. Furthermore, the fifth and sixth selection signal lines are commonly connected to the third pixel included in the plurality of pixels PX. Details of a connection relationship of the first to sixth selection signal lines will be described below with reference to FIG. 8 through FIG. 12.

In some exemplary embodiments, the display device 100 may further include a power unit. In this case, a signal for operating each pixel PX may be supplied through a power line connecting the power unit to the display panel PN. In some exemplary embodiments, the power unit may supply power to the data driver DD and the gate driver GD. The data driver DD and the gate driver GD may be driven based on the power supplied from the power unit. However, the present disclosure is not limited to the above exemplary embodiments.

For example, the data driver DD may apply a data signal to pixels PX through the plurality of data lines DL, respectively, and the gate driver GD may apply a gate signal to pixels PX through the plurality of gate lines GL, respectively. Also, the power unit may supply a power voltage to pixels PX through power voltage supply lines, respectively. However, the present disclosure is not limited to the above example.

The timing controller TD may control the data driver DD and the gate driver GD. For example, the timing controller TD may realign digital video data input from the outside in accordance with the resolution of the display panel PN and may supply the realigned digital video data to the data driver DD. However, the present disclosure is not limited thereto.

The data driver DD may convert the digital video data input from the timing controller TD into an analog data voltage based on a data control signal and may supply the analog data voltage to the plurality of data lines DL. However, the present disclosure is not limited thereto.

The gate driver GD may generate a scan signal and an emission signal (or emission control signal) based on a gate control signal. For example, the gate driver GD may include a scan driver and an emission signal driver. The scan driver may generate scan signals in a row sequential manner to drive at least one scan line connected to each pixel row and may supply the scan signals to the scan lines. The emission signal driver may generate emission signals in a row sequential manner to drive at least one emission signal line connected to each pixel row and may supply the emission signals to the emission signal lines. However, the present disclosure is not limited thereto.

In some exemplary embodiments, the gate driver GD may be disposed on the display panel DP in a Gate-driver In Panel (GIP) method, without being limited thereto. For example, the gate driver GD may be divided into a plurality of gate drivers GD and then disposed on at least two lateral surfaces of the display panel PN, respectively.

The mode controller MS may control the mode selection unit MD. For example, the mode controller MS may generate a mode selection signal MSS for controlling the mode selection unit MD based on a mode signal input depending on a driving mode of the display device 100 and may supply the mode selection signal MSS to the mode selection unit MD. The mode selection unit MD may supply a selection signal to the plurality of selection signal lines SSL in response to the mode selection signal MSS. However, the present disclosure is not limited thereto.

The display panel PN may include a display area and a non-display area surrounding the display area or disposed adjacent to the display area.

The display area of the display panel PN may include a plurality of pixels PX disposed in the row direction and the column direction. For example, the plurality of pixels PX may be disposed at intersections between the plurality of data lines DL and the plurality of gate lines GL. However, the present disclosure is not limited thereto.

Each pixel PX may include a plurality of sub-pixels which emits light of different colors. For example, each pixel PX may implement blue, red, and green colors by using three sub-pixels, but is not limited thereto. In some exemplary embodiments, the pixel PX may further include a sub-pixel for implementing light of a specific color (e.g., white light, visible light, or even invisible light). However, the present disclosure is not limited thereto.

In the pixel PX, a region implementing blue may be referred to as a blue sub-pixel, a region implementing red may be referred to as a red sub-pixel, and a region implementing green may be referred to as a green sub-pixel, without being limited thereto. As an example, sub-pixels emitting light of other colors (such as, magenta, cyan, or yellow) are also possible.

Each of the plurality of pixels PX may include a first type light emitting diode and a second type light emitting diode which emit light of the same color.

Each of the plurality of pixels PX may include at least one of a first type lens and a second type lens which refract light from the first type light emitting diode and the second type light emitting diode in a specific direction. Meanwhile, the term "lens" is used herein for the convenience of description and may also be defined as "optical member".

For example, the first type lens may be disposed in a lens area which supplies light to a first range to form a first viewing angle. Also, the second type lens may be disposed in a lens area which supplies light to a second range to form a second viewing angle. The first range may be wider than the second range, without being limited thereto. Thus, a viewing angle of each of the plurality of pixels PX may be limited by the first type lens and the second type lens.

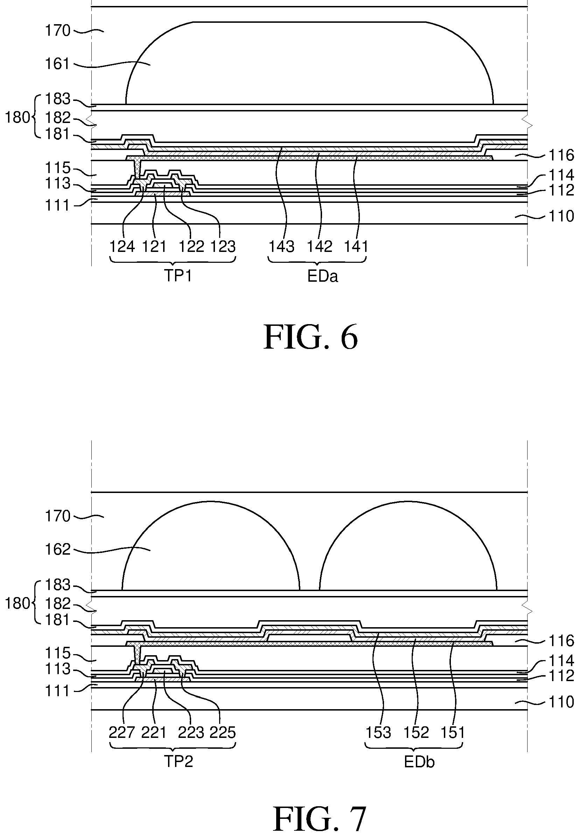

Details of the first type lens and the second type lens will be described below with reference to FIG. 6 and FIG. 7.

The non-display area may be disposed along the circumference of the display area. Various components for driving the pixel circuit disposed in the pixel PX may be disposed in the non-display area. For example, at least a part of the gate driver GD may be disposed in the non-display area. The non-display area may be referred to as a bezel area.

The display panel PN may be divided into a plurality of areas. In other words, the display panel PN may include a plurality of areas. For example, the display panel PN may include a first area in which a plurality of first pixels and a plurality of second pixels among the plurality of pixels PX are disposed. Also, the display panel PN may include a second area in which a plurality of third pixels among the plurality of pixels PX is disposed. Each of the plurality of first pixels and the plurality of second pixels disposed in the first area and the plurality of third pixels disposed in the second area may include the same or the substantially same pixel circuit, without being limited thereto.

For example, each of the plurality of first pixels and the plurality of second pixels disposed in the first area of the display panel PN and the plurality of third pixels disposed in the second area may include a driver circuit, a selection circuit, and the first and second type light emitting diodes which emit light of the same or the substantially same color, but is not limited thereto, and may include more or less elements than shown.

Herein, the driver circuit may serve to supply a driving current to the first type light emitting diode and the second type light emitting diode based on signals supplied form the data driver DD and the gate driver GD. However, the present disclosure is not limited thereto.

Also, the selection circuit may serve to control the generation of one of a first driving current flowing through the first type light emitting diode and a second driving current flowing through the second type light emitting diode based on a selection signal supplied from the mode selection unit MD. In other words, the selection circuit may control the formation of a current path of the first driving current to allow the first type light emitting diode to emit light. Alternatively, the selection circuit may control the formation of a current path of the second driving current to allow the second type light emitting diode to emit light. However, the present disclosure is not limited thereto. The selection circuit may be included in the driver circuit.

Hereinafter, for the convenience of description, a pixel PX being driven in a first state is defined by when a current path of a first driving current is formed and the first type light emitting diode emits light. Also, a pixel PX being driven in a second state is defined by when a current path of a second driving current is formed and the second type light emitting diode emits light. However, the present disclosure is not limited thereto.

The selection circuit may serve to control the generation of all of a first driving current flowing through the first type light emitting diode and a second driving current flowing through the second type light emitting diode based on a selection signal supplied from the mode selection unit MD. In other words, the selection circuit may control the formation of a current path of the first driving current and a current path of the second driving current to allow both of the first type light emitting diode and the second type light emitting diode to emit light. However, the present disclosure is not limited thereto. The selection circuit may be included in the driver circuit.

Hereinafter, for the convenience of description, a pixel PX being driven in a third state is defined by when each of a current path of a first driving current and a current path of a second driving current is formed and both of the first type light emitting diode and the second type light emitting diode emit light.

Each of the plurality of first pixels disposed in the first area of the display panel PN may include two first type lenses configured to respectively refract light emitted from the first type light emitting diode and light emitted from the second type light emitting diode in a specific direction. The two first type lenses may include, for example, a first lens and a second lens. For example, light emitted from the first type light emitting diode included in each of the plurality of first pixels disposed in the first area of the display panel PN may be refracted in a specific direction by the first lens which is implemented as the first type lens. Also, light emitted from the second type light emitting diode included in each of the plurality of first pixels disposed in the first area of the display panel PN may be refracted in a specific direction by the second lens which is implemented as the first type lens.

Each of the plurality of second pixels disposed in the first area of the display panel PN and the plurality of third pixels disposed in the second area may include the first type lens, e.g., a third lens or a fifth lens, configured to refract light emitted from the first type light emitting diode in a specific direction. Also, each of the plurality of second pixels disposed in the first area of the display panel PN and the plurality of third pixels disposed in the second area may include the second type lens, e.g., a fourth lens or a sixth lens, configured to refract light emitted from the second type light emitting diode in a specific direction. For example, light emitted from the first type light emitting diode included in each of the plurality of second pixels disposed in the first area of the display panel PN may be refracted in a specific direction by the third lens which is implemented as the first type lens. Also, light emitted from the second type light emitting diode included in each of the plurality of second pixels disposed in the first area of the display panel PN may be refracted in a specific direction by the fourth lens which is implemented as the second type lens. As another example, light emitted from the first type light emitting diode included in each of the plurality of third pixels disposed in the second area of the display panel PN may be refracted in a specific direction by the fifth lens which is implemented as the first type lens. Also, light emitted from the second type light emitting diode included in each of the plurality of third pixels disposed in the second area of the display panel PN may be refracted in a specific direction by the sixth lens which is implemented as the second type lens. However, the present disclosure is not limited thereto.

Details of the plurality of areas, e.g., the first area and the second area, included in the display panel PN and the first to third pixels disposed in the first area and the second area will be described below with reference to FIG. 8 through FIG. 18.

In some exemplary embodiments, each area of the display panel PN may be disposed to extend across the driver seat and the front passenger seat, which are front seats in the vehicle, as described above with reference to FIG. 1. Also, each area of the display panel PN may supply various kinds of information to the driver and the passenger. For example, the first area of the display panel PN is disposed on the driver seat side and supplies information, such as driving speed, RPM, engine temperature, and fuel amount to the driver. Also, the second area of the display panel PN is disposed on the front passenger seat side and supplies entertainment functions and seat information to the passenger on the front passenger seat. Meanwhile, the first area of the display panel PN may further include a center fascia area disposed between the driver seat and the front passenger seat. However, the definition of the areas is made for the convenience of description, and the first area and the second area of the display panel PN may be defined variously depending on the design. However, the present disclosure is not limited thereto.

Meanwhile, when the display panel PN is used for the vehicle described above with reference to FIG. 1, at last some of the plurality of areas included in the display panel PN need to be limited in viewing angle according to the user's demand. For example, an image displayed in the second area which supplies entertainment functions and seat information to the passenger on the front passenger seat may disturb the driver's driving of the vehicle. Therefore, a viewing angle of the image displayed in the second area may need to be limited according to the user's demand.

More specifically, referring to FIG. 2, the display device 100 may use the mode controller MS and the mode selection unit MD to control a viewing angle of at least some of the plurality of areas included in the display panel PN. However, the present disclosure is not limited thereto.

The mode controller MS may generate the mode selection signal MSS for controlling the display panel PN to be driven in a first mode or a second mode depending on a driving mode of the display device 100 and supply the mode selection signal MSS to the mode selection unit MD. Herein, the first mode refers to a mode in which a plurality of areas, e.g., the first area and the second area, of the display panel PN is driven in a share mode. Also, the second mode refers to a mode in which at least some, e.g., the second area, of the plurality of areas, e.g., the first area and the second area, of the display panel PN is driven in a private mode.

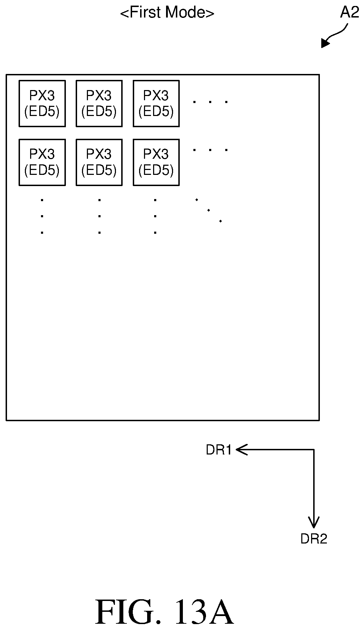

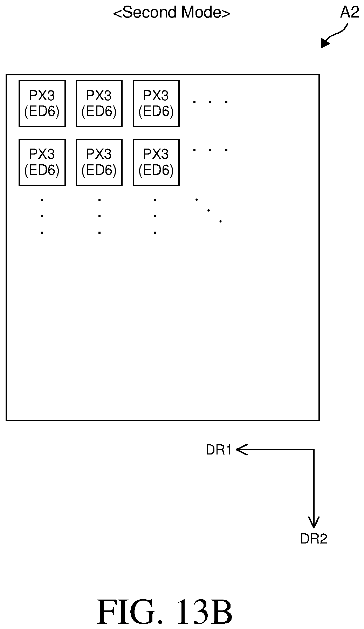

The configuration of the mode controller MS to control the display panel PN to be driven in the first mode or the second mode depending on a driving mode of the display device 100 will be described in detail with reference to FIG. 13A and FIG. 13B.

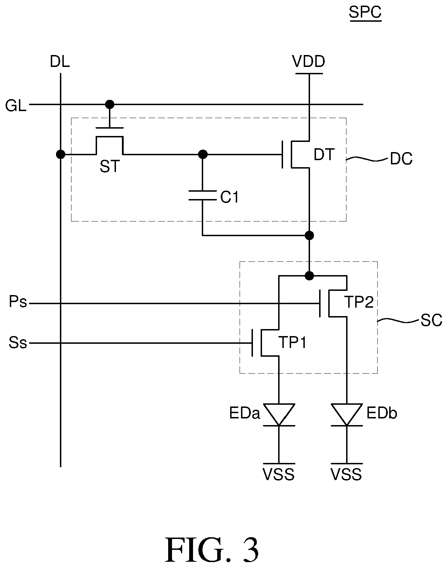

FIG. 3 is a circuit diagram illustrating an example of a pixel circuit of the display device according to an exemplary embodiment of the present disclosure.

Meanwhile, FIG. 3 illustrates an example of a pixel circuit SPC corresponding to each of the plurality of pixels PX of the display device 100.

Referring to FIG. 3, the pixel circuit SPC may include a driver circuit DC, a selection circuit SC, and a plurality of light emitting diodes EDa and EDb. Embodiments are not limited thereto. As an example, at least one of the above-mentioned components may be omitted, and/or one or more additional components could be further included.

As one example, the driver circuit DC may include a driving transistor DT, a switching transistor ST, and a first capacitor C1.

The driving transistor DT and the first capacitor C1 may be connected to the switching transistor ST. A first electrode of the driving transistor DT may be connected to a first power line which supplies a first power voltage VDD, e.g., a high-potential power voltage. A gate electrode of the driving transistor DT may be connected to the switching transistor ST. A second electrode of the driving transistor DT may be connected to the selection circuit SC.

A gate electrode of the switching transistor ST may be connected to a gate line GL and supplied with a gate signal. The switching transistor ST may be turned on or turned off by the gate signal. A first electrode of the switching transistor ST may be connected to a data line DL. A second electrode of the switching transistor ST may be connected to the driving transistor DT. In this case, the data signal may be supplied to a gate electrode of the driving transistor DT through the switching transistor ST in response to the switching transistor ST being turned-on.

The first capacitor C1 may be disposed between the gate electrode and the second electrode of the driving transistor DT. The first capacitor C1 can maintain a signal, e.g., a data signal, applied to the gate electrode of the driving transistor DT during one frame.

The selection circuit SC may include a first selection transistor TP1 for forming a current path of the first driving current flowing through the first type light emitting diode EDa. Also, the selection circuit SC may include a second selection transistor TP2 for forming a current path of the second driving current flowing through the second type light emitting diode EDb. However, the configuration of the selection circuit SC is not limited thereto.

The first selection transistor TP1 may be disposed between the driver circuit DC and the first type light emitting diode EDa. A gate electrode of the first selection transistor TP1 may be connected to a first type selection signal line which supplies a first selection signal Ss. The first selection transistor TP1 may be turned on or turned off by the first selection signal Ss. If the first selection signal Ss is supplied to the gate electrode of the first selection transistor TP1 when the pixel circuit SPC is driven in the first state or the third state, the first selection transistor TP1 may be turned on. Thus, a current path of the first driving current flowing through the first type light emitting diode EDa may be formed. In this case, the first type light emitting diode EDa may emit light.

The second selection transistor TP2 may be disposed between the driver circuit DC and the second type light emitting diode EDb. A gate electrode of the second selection transistor TP2 may be connected to a second type selection signal line which supplies a second selection signal Ps. The second selection transistor TP2 may be turned on or turned off by the second selection signal Ps. If the second selection signal Ps is supplied to the gate electrode of the second selection transistor TP2 when the pixel circuit SPC is driven in the second state or the third state, the second selection transistor TP2 may be turned on. Thus, a current path of the second driving current flowing through the second type light emitting diode EDb may be formed. In this case, the second type light emitting diode EDb may emit light.

The first type light emitting diode EDa may be connected between the first selection transistor TP1 which is turned on or turned off by the first selection signal Ss and a second power line which supplies a second power voltage VSS, e.g., a low-potential power voltage. The second type light emitting diode EDb may be connected between the second selection transistor TP2 which is turned on or turned off by the second selection signal Ps and the second power line which supplies the second power voltage VSS, e.g., the low-potential power voltage.

In this case, the first type light emitting diode EDa or the second type light emitting diode EDb may be connected to another component of the pixel circuit SPC, e.g., the driving transistor DT of the driver circuit DC depending on a driving mode. Herein, the driving mode may be designated by the user's input or may be determined when a predetermined condition is satisfied.

For example, the driving mode may include the first mode in which the plurality of areas of the display panel PN described above with reference to FIG. 1 is driven in the share mode. Also, the driving mode may include the second mode in which at least some, e.g., the second area, of the plurality of areas of the display panel PN is driven in the private mode.

The plurality of transistors DT, ST, TP1 and TP2 of FIG. 3 may include at least one of amorphous silicon, polycrystalline silicon and an oxide semiconductor, such as IGZO. Embodiments are not limited thereto. As an example, the plurality of transistors DT, ST, TP1 and TP2 of FIG. 3 may be implemented as transistors having the same or different semiconductors. A first electrode or a second electrode of the transistor may be a source electrode or a drain electrode. For example, the first electrode may be a source electrode, and the second electrode may be a drain electrode. As another example, the first electrode may be a drain electrode, and the second electrode may be a source electrode.

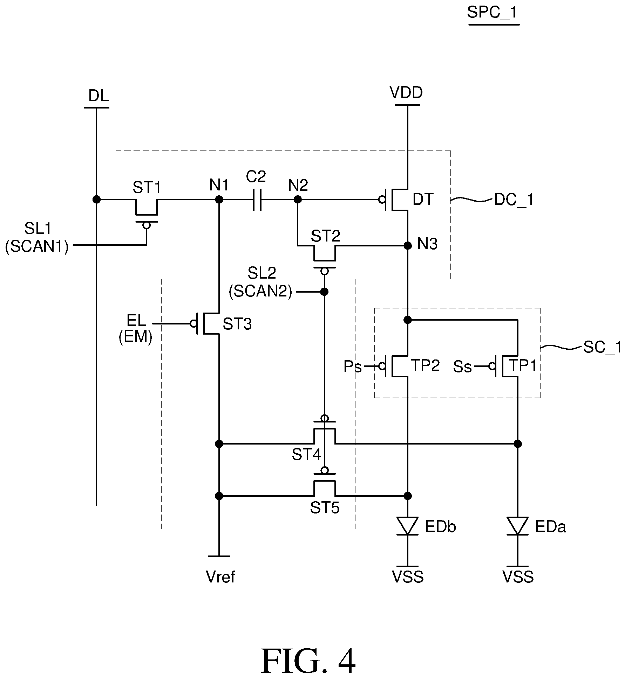

FIG. 4 is a circuit diagram illustrating an example of a pixel circuit of the display device according to an exemplary embodiment of the present disclosure.

Meanwhile, FIG. 4 illustrates an example of a pixel circuit SPC_1 which can be applied to the pixel circuit SPC of FIG. 3.

Referring to FIG. 4, at least some of a plurality of transistors included in the pixel circuit SPC_1 may be n-type transistors or p-type transistors. In a p-type transistor, a low level voltage of each driving signal means a voltage for turning on a transistor, and a high level voltage of each driving signal may mean a voltage for turning off the transistor. In a n-type transistor, a low level voltage of each driving signal means a voltage for turning off a transistor, and a high level voltage of each driving signal may mean a voltage for turning on the transistor.

Herein, the low level voltage may correspond to a predetermined voltage lower than the high level voltage. For example, the low level voltage may include a voltage in the range of -8 V to -12 V, but is not limited thereto. The high level voltage may correspond to a predetermined voltage higher than the low level voltage. For example, the high level voltage may include a voltage in the range of 12 V to 16 V, but is not limited thereto. In some exemplary embodiments, the low level voltage may be referred to as a first voltage, and the high level voltage may be referred to as a second voltage. In this case, the first voltage may have a value lower than the second voltage.

A first electrode or a second electrode of a transistor to be described below may refer to a source electrode or a drain electrode. However, the terms, such as the first electrode and the second electrode, are used to distinguish each electrode, and do not limit what each electrode corresponds to. Further, the first electrode may not refer to the same electrode for each electrode.

Referring to FIG. 4, the pixel circuit SPC_1 may include a driver circuit DC_1, a selection circuit SC_1, and the plurality of light emitting diodes EDa and EDb.

The driver circuit DC_1 may include the driving transistor DT, a plurality of switching transistors ST1 to ST5, and a second capacitor C2.

The driving transistor DT may control a driving current to be applied to the plurality of light emitting diodes EDa and EDb according to a source-gate voltage. The driving transistor DT may include a first electrode (such as a source electrode) connected to the first power line which supplies the first power voltage VDD, a gate electrode connected to a second node N2, and a second electrode (such as a drain electrode) connected to a third node N3.

The first switching transistor ST1 may apply a data signal from the data line DL to a first node N1. The first switching transistor ST1 may include a first electrode (such as a source electrode) connected to the data line DL, a second electrode (such as a drain electrode) connected to the first node N1, and a gate electrode connected to a first scan signal line SL1 to which a first scan signal SCAN1 is applied. The first switching transistor ST1 may be turned on or turned off by the first scan signal SCAN1. Thus, the first switching transistor ST1 may apply a data signal from the data line DL to the first node N1 in response to the first scan signal SCAN1. For example, the first switching transistor ST1 may apply a data signal from the data line DL to the first node N1 in response to the first scan signal SCAN1 of a low level, which is a turn-on level.

The second switching transistor ST2 may diode-connect the gate electrode and the drain electrode of the driving transistor DT. The second switching transistor ST2 may include a first electrode (such as a drain electrode) connected to the second node N2, a second electrode (such as a source electrode) connected to the third node N3, and a gate electrode connected to a second scan signal line SL2 to which a second scan signal SCAN2 is applied. The second switching transistor ST2 may be turned on or turned off by the second scan signal SCAN2. Thus, the second switching transistor ST2 may diode-connect the gate electrode and the drain electrode of the driving transistor DT in response to the second scan signal SCAN2. For example, the second switching transistor ST2 may diode-connect the gate electrode and the drain electrode of the driving transistor DT in response to the second scan signal SCAN2 of a low level, which is a turn-on level.

The third switching transistor ST3 may apply a reference voltage Vref to the first node N1. The third switching transistor ST3 may include a first electrode (such as a source electrode) connected to a reference voltage line which supplies the reference voltage Vref, a second electrode (such as a drain electrode) connected to the first node N1, and a gate electrode connected to an emission signal line EL to which an emission signal EM is applied. The third switching transistor ST3 may be turned on or turned off by the emission signal EM. Thus, the third switching transistor ST3 may apply the reference voltage Vref to the first node N1 in response to the emission signal EM. For example, the third switching transistor ST3 may apply the reference voltage Vref to the first node N1 in response to the emission signal EM of a low level, which is a turn-on level.

The fourth switching transistor ST4 may apply the reference voltage Vref to an anode of the first type light emitting diode EDa. The fourth switching transistor ST4 may include a first electrode (such as a source electrode) connected to the reference voltage line which supplies the reference voltage Vref, a second electrode (such as a drain electrode) connected to the anode of the first type light emitting diode EDa, and a gate electrode connected to the second scan signal line SL2 to which the second scan signal SCAN2 is applied. The fourth switching transistor ST4 may be turned on or turned off by the second scan signal SCAN2. Thus, the fourth switching transistor ST4 may apply the reference voltage Vref to the anode of the first type light emitting diode EDa in response to the second scan signal SCAN2. For example, the fourth switching transistor ST4 may apply the reference voltage Vref to the anode of the first type light emitting diode EDa in response to the second scan signal SCAN2 of a low level, which is a turn-on level

The fifth switching transistor ST5 may apply the reference voltage Vref to an anode of the second type light emitting diode EDb. The fifth switching transistor ST5 may include a first electrode (such as a source electrode) connected to the reference voltage line which supplies the reference voltage Vref, a second electrode (such as a drain electrode) connected to the anode of the second type light emitting diode EDb, and a gate electrode connected to the second scan signal line SL2 to which the second scan signal SCAN2 is applied. The fifth switching transistor ST5 may be turned on or turned off by the second scan signal SCAN2. Thus, the fifth switching transistor ST5 may apply the reference voltage Vref to the anode of the second type light emitting diode EDb in response to the second scan signal SCAN2. For example, the fifth switching transistor ST5 may apply the reference voltage Vref to the anode of the second type light emitting diode EDb in response to the second scan signal SCAN2 of a low level, which is a turn-on level.

The second capacitor C2 may include a first electrode connected to the first node N1 and a second electrode connected to the second node N2. That is, one electrode of the second capacitor C2 may be connected to the gate electrode of the driving transistor DT, and the other electrode of the second capacitor C2 may be connected to the first switching transistor ST1. The second capacitor C2 may store a predetermined voltage to maintain a constant voltage level of the gate electrode of the driving transistor DT while at least one of the plurality of light emitting diodes EDa and EDb emits light. However, the present disclosure is not limited thereto.

The selection circuit SC_1 may include the first selection transistor TP1 for forming a current path of the first driving current flowing through the first type light emitting diode EDa. Also, the selection circuit SC_1 may include the second selection transistor TP2 for forming a current path of the second driving current flowing through the second type light emitting diode EDb. However, the present disclosure is not limited thereto.

The first selection transistor TP1 may be disposed between the driver circuit DC_1 and the first type light emitting diode EDa. The gate electrode of the first selection transistor TP1 may be connected to the first type selection signal line which supplies the first selection signal Ss. The first selection transistor TP1 may be turned on or turned off by the first selection signal Ss. If the first selection signal Ss is supplied to the gate electrode of the first selection transistor TP1 when the pixel circuit SPC_1 is driven in the first state or the third state, the first selection transistor TP1 may be turned on. Thus, a current path of the first driving current flowing through the first type light emitting diode EDa may be formed. In this case, the first type light emitting diode EDa may emit light.

The second selection transistor TP2 may be disposed between the driver circuit DC_1 and the second type light emitting diode EDb. The gate electrode of the second selection transistor TP2 may be connected to the second type selection signal line which supplies the second selection signal Ps. The second selection transistor TP2 may be turned on or turned off by the second selection signal Ps. If the second selection signal Ps is supplied to the gate electrode of the second selection transistor TP2 when the pixel circuit SPC_1 is driven in the second state or the third state, the second selection transistor TP2 may be turned on. Thus, a current path of the second driving current flowing through the second type light emitting diode EDb may be formed. In this case, the second type light emitting diode EDb may emit light.

The first type light emitting diode EDa may be connected between the first selection transistor TP1 which is turned on or turned off by the first selection signal Ss and the second power line which supplies the second power voltage VSS, e.g., the low-potential power voltage. The second type light emitting diode EDb may be connected between the second selection transistor TP2 which is turned on or turned off by the second selection signal Ps and the second power line which supplies the second power voltage VSS, e.g., the low-potential power voltage. However, the present disclosure is not limited thereto.

In this case, the first type light emitting diode EDa or the second type light emitting diode EDb may be connected to another component of the pixel circuit SPC_1, e.g., the driving transistor DT of the driver circuit DC_1 depending on a driving mode. Herein, the driving mode may be designated by the user's input or may be determined when a predetermined condition is satisfied.

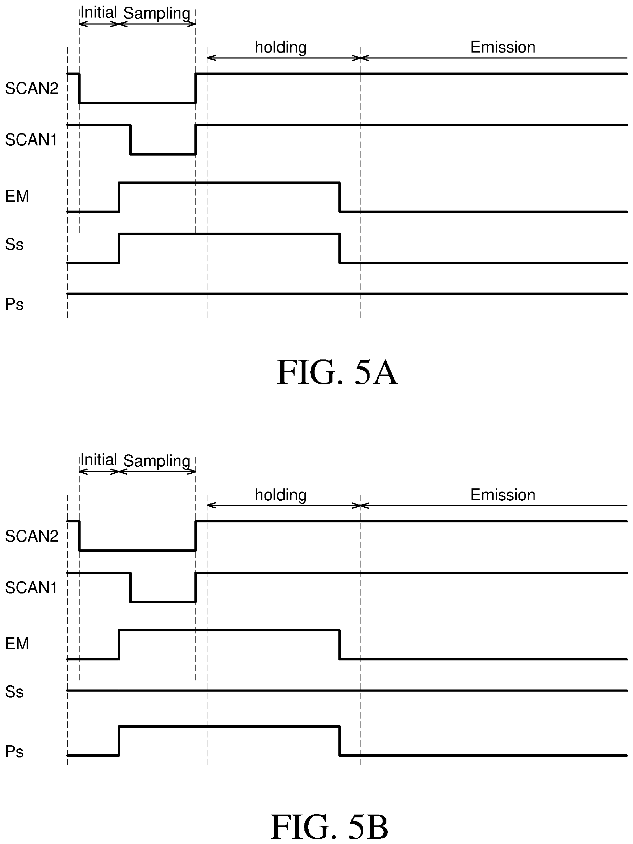

FIG. 5A and FIG. 5B are waveform diagrams for explaining the pixel circuit of FIG. 4.

Meanwhile, FIG. 5A shows a waveform diagram for explaining an example where the pixel circuit SPC_1 is driven in the first state. FIG. 5B shows a waveform diagram for explaining an example where the pixel circuit SPC_1 is driven in the second state.

Referring to FIG. 4 through FIG. 5B, when the pixel circuit SPC_1 is driven in the first state, only the first type light emitting diode EDa may emit light. Also, when the pixel circuit SPC_1 is driven in the second state, only the second type light emitting diode EDb may emit light. Also, the first selection transistor TP1 may be turned on by the first selection signal Ss of a low level, and the second selection transistor TP2 may be turned off by the second selection signal Ps of a high level. Herein, as shown in FIG. 5A, the second selection signal Ps for controlling the emission of the second type light emitting diode EDb, i.e., the second selection signal Ps for forming a current path of the second driving current may be output only at a high level, which is a turn-off level, to allow only the first type light emitting diode EDa to emit light in the first state. Also, the first selection transistor TP1 may be turned off by the first selection signal Ss of a high level, and the second selection transistor TP2 may be turned on by the second selection signal Ps of a low level. Also, as shown in FIG. 5B, the first selection signal Ss for controlling the emission of the first type light emitting diode EDa, i.e., the first selection signal Ss for forming a current path of the first driving current may be output only at a high level, which is a turn-off level, to allow only the second type light emitting diode EDb to emit light in the second state.

Specifically, an operation of the pixel circuit SPC_1 in the first state will be described with reference to FIG. 4 and FIG. 5A. The second scan signal SCAN2 of a low level, the first selection signal Ss of a low level, and the emission signal EM of a low level may be output in an initial period. The second switching transistor ST2, the fourth switching transistor ST4, and the fifth switching transistor ST5 may be turned on by the second scan signal SCAN2 of a low level. Also, the first selection transistor TP1 may be turned on by the first selection signal Ss of a low level. Further, the third switching transistor ST3 may be turned on by the emission signal EM of a low level.

A voltage of the first node N1 may be initialized to the reference voltage Vref through the turned-on third switching transistor ST3. A voltage of the anode of the first type light emitting diode EDa may be initialized to the reference voltage Vref through the turned-on fourth switching transistor ST4. Also, a voltage of the anode of the second type light emitting diode EDb may be initialized to the reference voltage Vref through the turned-on fifth switching transistor ST5. Further, the driving transistor DT may be diode-connected through the turned-on second switching transistor ST2 and the gate electrode and the drain electrode of the driving transistor DT may be short-circuited. Thus, the driving transistor DT may operate like a diode. Furthermore, the reference voltage Vref transmitted to the anode of the first type light emitting diode EDa through the turned-on fourth switching transistor ST4 may be transmitted to the third node N3 and the second node N2 through the turned-on first selection transistor TP1 and second switching transistor ST2. Thus, the third node N3 and the second node N2 may be initialized to the reference voltage Vref. However, the present disclosure is not limited thereto.

Then, the first scan signal SCAN1 of a low level and the second scan signal SCAN2 of a low level may be output in a sampling period. Also, the first selection signal Ss and the emission signal EM may be output from a low level to a high level in the sampling period. When the emission signal EM of a high level is output, the third switching transistor ST3 may be turned off. At the same time, the first switching transistor ST1 may be turned on by the first scan signal SCAN1 of a low level. Further, the second switching transistor ST2 may be turned on by the second scan signal SCAN2 of a low level. Thus, the data signal may be transmitted to the first node N1. Also, the driving transistor DT may be diode-connected by the turned-on second switching transistor ST2, and a voltage difference between the first power voltage VDD and a threshold voltage may be sampled and then supplied to the second node N2.

Further, the first scan signal SCAN1 and the second scan signal SCAN2 may be output at a high level in a holding period. Thus, all of the first switching transistor ST1, the second switching transistor ST2, the fourth switching transistor ST4, and the fifth switching transistor ST5 may be turned off. However, even when the first switching transistor ST1 is turned off, the data signal (data voltage) input in the previous period (e.g., sampling period) may be maintained by the second capacitor C2. However, the present disclosure is not limited thereto.

Finally, the first selection signal Ss of a low level, the emission signal EM of a low level, and the second selection signal Ps of a high level may be output in an emission period. The reference voltage Vref may be applied to the first node N1 through the third switching transistor ST3 which is turned on by the emission signal EM of a low level. A voltage of the first node N1 may be a voltage difference between the reference voltage Vref and the data signal (data voltage). Such a voltage variation may be reflected to the second node N2. A gate-source voltage of the driving transistor DT may be set to a value Vdata-Vref+Vth obtained by subtracting the reference voltage Vref from the data signal (data voltage) and adding the data signal (data voltage). Thus, the first driving current may be controlled.

The first selection signal Ss is output at a low level, and thus, the first selection transistor TP1 is turned on. Also, the first driving current may be supplied from the driving transistor DT to the first type light emitting diode EDa through the turned-on first selection transistor TP1. Thus, the first type light emitting diode EDa may emit light. However, the second selection signal Ps is output at a high level, and, thus, the second selection transistor TP2 is turned off. Therefore, the second driving current cannot be transmitted from the driving transistor DT to the second type light emitting diode EDb. Accordingly, when the pixel circuit SPC_1 is driven in the first state, the first driving current may be applied only to the first type light emitting diode EDa. Thus, only the first type light emitting diode EDa may emit light.

Hereinafter, an operation of the pixel circuit SPC_1 in the second state will be described with reference to FIG. 4 and FIG. 5B. The pixel circuit SPC_1 may be driven in the second state in substantially the same manner as in the first state except that the first selection signal Ss and the second selection signal Ps are output reversely to the first state. That is, the first selection signal Ss may be output only at a high level, which is a turn-off level. Also, the second selection signal Ps may be output at a low level, which is a turn-on level, during the emission period in which the second type light emitting diode EDb emits light. However, the present disclosure is not limited thereto.

Specifically, the first scan signal SCAN1 of a high level and the second scan signal SCAN2 of a low level may be output in the initial period. Also, the first selection signal Ss may be output at a high level, and the second selection signal Ps and the emission signal EM may be output at a low level. Thus, the second switching transistor ST2, the fourth switching transistor ST4, and the fifth switching transistor ST5 may be turned on by the second scan signal SCAN2. Further, the second selection transistor TP2 may be turned on by the second selection signal Ps, and the third switching transistor ST3 may be turned on by the emission signal EM. Further, the first selection transistor TP1 may be turned off by the first selection signal Ss of a high level. At the same time, the first switching transistor ST1 may be turned off by the first scan signal SCAN1 of a high level.

A voltage of the first node N1 may be initialized to the reference voltage Vref through the third switching transistor ST3 which is turned on by the emission signal EM. The anodes of the first type light emitting diode EDa and the second type light emitting diode EDb may be initialized to the reference voltage Vref by the fourth switching transistor ST4 and the fifth switching transistor ST5, respectively, which are turned on by the second scan signal SCAN2. Further, the driving transistor DT may be diode-connected through the turned-on second switching transistor ST2 and may operate like a diode. Finally, the reference voltage Vref transmitted to the anode of the second type light emitting diode EDb through the turned-on fifth switching transistor ST5 may be transmitted to the third node N3 and the second node N2 through the turned-on second selection transistor TP2 and second switching transistor ST2. Thus, the third node N3 and the second node N2 may be initialized to the reference voltage Vref.

Then, the first scan signal SCAN1 of a low level and the second scan signal SCAN2 of a low level may be output in the sampling period. Also, the second selection signal Ps and the emission signal EM may be output from a low level to a high level in the sampling period. When the emission signal EM of a high level is output, the third switching transistor ST3 may be turned off. When the first switching transistor ST1 is turned on by the first scan signal SCAN1 of a low level, the data signal may be transmitted to the first node N1. Further, the second switching transistor ST2 may be turned on by the second scan signal SCAN2 of a low level. Also, the driving transistor DT may be diode-connected through the turned-on second switching transistor ST2, and a voltage difference between the first power voltage VDD and the threshold voltage may be sampled and then supplied to the second node N2.

Finally, the second selection signal Ps of a low level, the emission signal EM of a low level, and the first selection signal Ss of a high level may be output in the emission period. The reference voltage Vref may be applied to the first node N1 through the third switching transistor ST3 which is turned on by the emission signal EM of a low level. A voltage of the first node N1 may be a voltage difference between the reference voltage Vref and the data signal (data voltage). Such a voltage variation may be reflected to the second node N2. A gate-source voltage of the driving transistor DT may be set to a value Vdata-Vref+Vth obtained by subtracting the reference voltage Vref from the data signal (data voltage) and adding the data signal (data voltage). Thus, the second driving current may be controlled.

Also, the second driving current may be supplied from the driving transistor DT to the second type light emitting diode EDb through the turned-on second selection transistor TP2. Thus, the second type light emitting diode EDb may emit light. However, the first selection signal Ss is output at a high level, and, thus, the first selection transistor TP1 is turned off. Therefore, the first driving current cannot be transmitted from the driving transistor DT to the first type light emitting diode EDa. Accordingly, when the pixel circuit SPC_1 is driven in the second state, the second driving current may be applied only to the second type light emitting diode EDb. Thus, only the second type light emitting diode EDb may emit light.

Although not shown in FIG. 5Aand FIG. 5B, when the pixel circuit SPC_1 is driven in the third state, both of the first type light emitting diode EDa and the second type light emitting diode EDb emit light. Thus, a waveform of the first selection signal Ss in the third state and an operation of the pixel circuit SPC_1 to form the first driving current are substantially the same as or similar to the waveform of the first selection signal Ss in the first state and the operation of the pixel circuit SPC_1 to form the first driving current described above with reference to FIG. 5A. Also, a waveform of the second selection signal Ps in the third state and an operation of the pixel circuit SPC_1 to form the second driving current are substantially the same as or similar to the waveform of the second selection signal Ps in the second state and the operation of the pixel circuit SPC_1 to form the second driving current described above with reference to FIG. 5B. Therefore, redundant description thereof will be omitted or briefly provided.

FIG. 6 and FIG. 7 are cross-sectional views of the display device according to an exemplary embodiment of the present disclosure.

FIG. 6 illustrates a pixel in which a first type lens 161 is disposed, and FIG. 7 illustrates a pixel in which a second type lens 162 is disposed.

Referring to FIG. 6 and FIG. 7, the display device 100 according to an exemplary embedment of the present disclosure may include a substrate 110, a buffer film 111, a gate insulating film 112, and an interlayer insulating film 113, but is not limited thereto. Also, the display device 100 may further include a lower protection film 114, an overcoating layer 115, a bank insulating film 116, the first selection transistor TP1, and the second selection transistor TP2, but is not limited thereto. Further, the display device 100 may further include the first type light emitting diode EDa, the second type light emitting diode EDb, the first type lens 161, the second type lens 162, a lens protection film 170, and an encapsulation member 180.

The substrate 110 may contain an insulating material. The substrate 110 may contain a transparent material. For example, the substrate 110 may contain glass, plastic, or a flexible polymer film, but is not limited thereto. For example, the flexible polymer film may be made of any one of polyethylene terephthalate(PET), polycarbonate(PC), acrylonitrile-butadienestyrene copolymer(ABS), polymethyl methacrylate(PMMA), polyethylene naphthalate(PEN), polyether sulfone(PES), cyclic olefin copolymer(COC), triacetylcellulose(TAC) film, polyvinyl alcohol(PVA) film, polyimide(PI) film, and polystyrene(PS), which is only an example and is not necessarily limited thereto.

The buffer film 111 may be disposed on the substrate 110. The buffer film 111 may contain an insulating material. For example, the buffer film 111 may contain an inorganic insulating material, such as silicon oxide (SiOx) and silicon nitride (SiNx). The buffer film 111 may have a multilayer structure. For example, the buffer film 111 may have a structure in which a film of silicon nitride (SiNx) and a film of silicon oxide (SiOx) are laminated.

The buffer film 111 may be located between the substrate 110 and a driving portion, e.g., the driver circuit DC, of each pixel PX. The buffer film 111 may reduce or suppress contamination caused by the substrate 110 in a process of forming the driving portion. For example, an upper surface of the substrate 110 directed toward the driving portion of each pixel PX may be covered by the buffer film 111. The driving portion of each pixel PX may be located on the buffer film 111.

The gate insulating film 112 may be disposed on the buffer film 111. The gate insulating film 112 may contain an insulating material. For example, the gate insulating film 112 may contain an inorganic insulating material, such as silicon oxide (SiO) and silicon nitride (SiN). The gate insulating film 112 may contain a material having a high dielectric constant. For example, the gate insulating film 112 may contain a high-K material, such as hafnium oxide (HfO). The gate insulating film 112 may have a single layer structure or a multilayer structure, without being limited thereto.

The gate insulating film 112 may extend between a semiconductor layer 121 or 221 and a gate electrode 122 or 223 of the selection transistor TP1 or TP2, respectively. For example, the gate electrodes of the driving transistor DT and the switching transistor ST may be insulated from the semiconductor layers of the driving transistor DT and the switching transistor ST by the gate insulating film 112. The gate insulating film 112 may cover a semiconductor layer of each pixel PX. The gate electrodes of the driving transistor DT and the switching transistor ST may be located on the gate insulating film 112.

The semiconductor layer 121 or 221 may include silicon such as amorphous silicon (a-Si), polysilicon (poly-Si), or low temperature poly-Si or may include oxide such as indium-gallium-zinc-oxide (IGZO), but embodiments of the present disclosure are not limited thereto.

The interlayer insulating film 113 may be disposed on the gate insulating film 112. The interlayer insulating film 113 may contain an insulating material. For example, the interlayer insulating film 113 may contain an inorganic insulating material, such as silicon oxide (SiO) and silicon nitride (SiN). The interlayer insulating film 113 may extend between the gate electrode and the source electrode and between the gate electrode and the drain electrode of each of the driving transistor DT and the switching transistor ST. For example, the source electrode and the drain electrode of each of the driving transistor DT and the switching transistor ST may be insulated from the gate electrode by the interlayer insulating film 113. The interlayer insulating film 113 may cover the gate electrode of each of the driving transistor DT and the switching transistor ST. A source electrode and a drain electrode of each pixel PX may be located on the interlayer insulating film 113. The gate insulating film 112 and the interlayer insulating film 113 may expose a source region and a drain region of each semiconductor pattern located in each pixel PX.

The lower protection film 114 may be disposed on the interlayer insulating film 113. The lower protection film 114 may contain an insulating material. For example, the lower protection film 114 may contain an inorganic insulating material, such as silicon oxide (SiO),silicon nitride (SiN) and silicon oxynitride (SiON). The lower protection film 114 may reduce or suppress damage to the driving portion caused by external moisture and impacts. The lower protection film 114 may extend along surfaces of the driving transistor DT and the switching transistor ST which face the substrate 110. The lower protection film 114 may be in contact with the interlayer insulating film 113 outside the driving portion located in each pixel PX.

The protection film may have a structure in which organic films and inorganic films are alternately stacked. The inorganic films may block the penetration of moisture or oxygen. The organic films may planarize a surface of the inorganic film. When the organic films and the inorganic films are stacked in multiple layers, the penetration of moisture/oxygen affecting the light emitting diode may be effectively blocked since a movement path of the moisture or oxygen is increased in length as compared with a single layer.

The overcoating layer 115 may be disposed on the lower protection film 114. The overcoating layer 115 may contain an insulating material. The overcoating layer 115 may contain a different material from the lower protection film 114. For example, the overcoating layer 115 may contain an organic insulating material. The overcoating layer 115 may remove a step difference caused by the driving portion of each pixel PX. For example, an upper surface of the overcoating layer 115 facing the substrate 110 may be a flat surface.

The first selection transistor TP1 and the second selection transistor TP2 may be disposed on the substrate 110. The first selection transistor TP1 may be electrically connected between the drain electrode of the driving transistor DT and a first lower electrode 141 of the first type light emitting diode EDa. The second selection transistor TP2 may be electrically connected between the drain electrode of the driving transistor DT and a second lower electrode 151 of the second type light emitting diode EDb. However, embodiments are not limited thereto.

The first selection transistor TP1 may include a first semiconductor layer 121, a first gate electrode 122, a first source electrode 123, and a first drain electrode 124. The first selection transistor TP1 may have the same or the substantially same structure as the switching transistor ST and the driving transistor DT. For example, the first semiconductor layer 121 may be located between the buffer film 111 and the gate insulating film 112. Also, the first gate electrode 122 may be located between the gate insulating film 112 and the interlayer insulating film 113. The first source electrode 123 and the first drain electrode 124 may be located between the interlayer insulating film 113 and the lower protection film 114. The first gate electrode 122 may overlap a channel region of the first semiconductor layer 121. The first source electrode 123 may be electrically connected to a source region of the first semiconductor layer 121. The first drain electrode 124 may be electrically connected to a drain region of the first semiconductor layer 121. However, embodiments are not limited thereto.

The second selection transistor TP2 may include a second semiconductor layer 221, a second gate electrode 223, a second source electrode 225, and a second drain electrode 227. For example, the second semiconductor layer 221 may be located on the same layer as the first semiconductor layer 121, and the second gate electrode 223 may be located on the same layer as the first gate electrode 122. Also, the second source electrode 225 and the second drain electrode 227 may be located on the same layer as the first source electrode 123 and the first drain electrode 124. However, embodiments are not limited thereto.

The first type light emitting diode EDa and the second type light emitting diode EDb of each pixel PX may be disposed on or above the overcoating layer 115 of the pixel PX.

The first type light emitting diode EDa may emit light of a specific color. For example, the first type light emitting diode EDa may include the first lower electrode 141, a first emission layer 142, and a first upper electrode 143 which are sequentially laminated on the substrate 110.

The first lower electrode 141 may contain a conductive material. The first lower electrode 141 may contain a material having a high reflectivity. For example, the first lower electrode 141 may contain a metal, such as aluminum (Al) and silver (Ag). The first lower electrode 141 may have a multilayer structure. For example, the first lower electrode 141 may have a structure in which a reflective electrode made of a metal is located between transparent electrodes made of a transparent conductive material, such as ITO and IZO. The first lower electrode 141 may be electrically connected to the first drain electrode 124 of the first selection transistor TP1 through a contact hole penetrating the lower protection film 114 and the overcoating layer 115.

The first emission layer 142 may generate light with a luminance corresponding to a voltage difference between the first lower electrode 141 and the first upper electrode 143. For example, the first emission layer 142 may include an emission material layer EML containing a light emitting material. The light emitting material may include an organic material, an inorganic material or a hybrid material.

The first emission layer 142 may have a multilayer structure. For example, the first emission layer 142 may further include at least one of a hole injection layer HIL, a hole transport layer HTL, an electron transport layer ETL, and an electron injection layer EIL, but the present disclosure is not limited thereto.

The first upper electrode 143 may contain a conductive material. The first upper electrode 143 may contain a different material from the first lower electrode 141. The first upper electrode 143 may have a higher transmittance than the first lower electrode 141, but the present disclosure is not limited thereto. For example, the first upper electrode 143 may be a transparent electrode made of a transparent conductive material, such as ITO and IZO. Therefore, in the display device 100 according to an exemplary embodiment of the present disclosure, light generated by the first emission layer 142 may be emitted through the first upper electrode 143.

The second type light emitting diode EDb may implement the same or the substantially same color as the first type light emitting diode EDa. The second type light emitting diode EDb may have the same or the substantially same structure as the first type light emitting diode EDa. For example, the second type light emitting diode EDb may include the second lower electrode 151, a second emission layer 152, and a second upper electrode 153 which are sequentially laminated on the substrate 110.

The second lower electrode 151 may correspond to the first lower electrode 141, the second emission layer 152 may correspond to the first emission layer 142, and the second upper electrode 153 may correspond to the first upper electrode 143. For example, the second lower electrode 151 may be provided in the second type light emitting diode EDb so as to have the same or the substantially same structure as the first lower electrode 141. The same applies to the second emission layer 152 and the second upper electrode 153. For example, the first type light emitting diode EDa and the second type light emitting diode EDb may be configured to have the same or the substantially same structure. However, the present disclosure is not limited thereto. In some exemplary embodiments, at least some components of the first type light emitting diode EDa and the second type light emitting diode EDb may be configured differently from each other.

The second emission layer 152 may be spaced apart from the first emission layer 142. Therefore, in the display device according to an exemplary embodiment of the present disclosure, it is possible to reduce or suppress light emission caused by a leakage current.

The second lower electrode 151 of each pixel PX may be spaced apart from the first lower electrode 141 of the pixel PX. For example, the bank insulating film 116 may be disposed between the first lower electrode 141 and the second lower electrode 151 of each pixel PX. The bank insulating film 116 may contain an insulating material. For example, the bank insulating film 116 may contain an organic insulating material, without being limited thereto. The bank insulating film 116 may contain a different material from the overcoating layer 115.

The second lower electrode 151 of each pixel PX may be insulated from the first lower electrode 141 of the pixel PX by the bank insulating film 116. For example, the bank insulating film 116 may cover an edge of the first lower electrode 141 and an edge of the second lower electrode 151 located in each pixel PX. Therefore, in the display device 100, an image formed by a first lens area of each pixel PX where the first type light emitting diode EDa is located or an image formed by a second lens area of each pixel PX where the second type light emitting diode EDb is located may be supplied to the user.

The first emission layer 142 and the first upper electrode 143 of the first type light emitting diode EDa located in each pixel PX may be laminated on a portion of the first lower electrode 141 exposed by the bank insulating film 116. The second emission layer 152 and the second upper electrode 153 of the second type light emitting diode EDb located in each pixel PX may be laminated on a portion of the second lower electrode 151 exposed by the bank insulating film 116. For example, the bank insulating film 116 may distinguish a first emission area in which light from the first type light emitting diode EDa in each pixel PX is emitted from a second emission area in which light from the second type light emitting diode EDb is emitted. The second emission area distinguished in each pixel PX may be smaller in size than the first emission area, without being limited thereto.

The second upper electrode 153 of each pixel PX may be electrically connected to the first upper electrode 143 of the pixel PX. For example, a voltage to be applied to the second upper electrode 153 of the second type light emitting diode EDb located in each pixel PX may be equal to a voltage to be applied to the first upper electrode 143 of the first type light emitting diode EDa located in the pixel PX. The second upper electrode 153 of each pixel PX may contain the same or the substantially same material as the first upper electrode 143 of the pixel PX, without being limited thereto. For example, the second upper electrode 153 of each pixel PX may be formed at the same time as the first upper electrode 143 of the pixel PX. The second upper electrode 153 of each pixel PX may extend onto the bank insulating film 116 so as to be in direct contact with the first upper electrode 143 of the pixel PX. A luminance of each of the first lens area and the second lens area located in each pixel PX may be controlled by a driving current generated in the pixel PX.

The encapsulation member 180 may be located on the first type light emitting diode EDa and the second type light emitting diode EDb of each pixel PX. The encapsulation member 180 may reduce or suppress damage to the light emitting diodes EDa and EDb caused by external moisture and impacts. The encapsulation member 180 may have a multilayer structure, without being limited thereto. For example, the encapsulation member 180 may include a first encapsulation layer 181, a second encapsulation layer 182, and a third encapsulation layer 183 which are sequentially laminated, but is not limited thereto. Each of the first encapsulation layer 181, the second encapsulation layer 182, and the third encapsulation layer 183 may contain an insulating material. The second encapsulation layer 182 may contain a different material from the first encapsulation layer 181 and the third encapsulation layer 183. For example, the first encapsulation layer 181 and the third encapsulation layer 183 may be inorganic encapsulation layers containing an inorganic insulating material, such as silicon oxide (SiOx) and silicon nitride (SiNx), and the second encapsulation layer 182 may be an organic encapsulation layer containing an organic insulating material, without being limited thereto. Therefore, it is possible to more effectively reduce or suppress damage to the light emitting diodes EDa and EDb of the display device 100 caused by external moisture and impacts.

The first type lens 161 and the second type lens 162 may be disposed on the encapsulation member 180, without being limited thereto.

The first type lens 161 may be disposed on the first type light emitting diode EDa. Light generated by the first type light emitting diode EDa of each pixel PX may be emitted through the first type lens 161 of the pixel PX. The first type lens 161 may have a shape in which light in at least one direction may not be limited. For example, the first type lens 161 located in each pixel PX may have a bar shape extending in one direction in a plan view. However, the present disclosure is not limited thereto.

In this case, a direction of light emitted from the first lens area of each pixel PX may not be limited to the one direction. For example, content (or images) supplied through the first lens area of each pixel PX may be shared with people adjacent to the user in the one direction. Therefore, content supplied by light emitted through the first type lens 161 may be displayed in a first viewing angle range wider than that of content supplied by light emitted through the second type lens 162, without being limited thereto. For example, the content supplied by light emitted through the first type lens 161 may be supplied in the share mode.

The second type lens 162 may be disposed on the second type light emitting diode EDb, without being limited thereto. Light generated by the second type light emitting diode EDb of each pixel PX may be emitted through the second type lens 162 of the pixel PX. The second type lens 162 may limit a direction of light passing through the second type lens 162 to the one direction and/or another direction. For example, the second type lens 162 located in each pixel PX may have a circular shape, an oval shape or the like in a plan view.

In this case, a direction of light emitted from the second lens area of each pixel PX may be limited to the one direction and/or the other direction. For example, content (or images) supplied through the second lens area of each pixel PX may not be shared with people adjacent to the user. Therefore, content supplied by light emitted through the second type lens 162 may be displayed in a second viewing angle range narrower than that of content supplied by light emitted through the first type lens 161. For example, the content supplied by light emitted through the second type lens 162 may be supplied in the private mode. However, the present disclosure is not limited thereto.

The first emission area of each pixel PX may correspond in shape to the first type lens 161 of the pixel PX. For example, the first emission area of each pixel PX may have a bar shape extending in one direction in a plan view. The first type lens 161 may be greater in size than the first emission area of the pixel PX, without being limited thereto. Therefore, the efficiency of light emitted from the first emission area of the pixel PX may be improved.

The second emission area of each pixel PX may correspond in shape to the second type lens 162 of the pixel PX. For example, the second emission area of each pixel PX may have a circular shape, an oval shape or the like in a plan view. The second type lens 162 may be greater in size than the second emission area of the pixel PX. Therefore, the efficiency of light emitted from the second emission area of the pixel PX may be improved.

The lens protection film 170 may be located on the first type lens 161 and the second type lens 162 of the pixel PX. The lens protection film 170 may contain an insulating material. For example, the lens protection film 170 may contain an organic insulating material, without being limited thereto. The lens protection film 17 may have a smaller refractive index than the first type lens 161 and the second type lens 162 located in each pixel PX. Therefore, in the display device 100 according to an exemplary embodiment of the present disclosure, light passing through the first type lens 161 and the second type lens 162 of each pixel PX may not be refracted toward the substrate 110 due to a difference in refractive index from the lens protection film 170.

Referring to FIG. 6 and FIG. 7, the pixel PX may include the first type lens 161 disposed on the first type light emitting diode EDa and the second type lens 162 disposed on the second type light emitting diode EDb as described above. However, the present disclosure is not limited there.

For example, the pixel PX may also include a plurality of first type lenses 161 disposed on each of the first type light emitting diode EDa and the second type light emitting diode EDb. Details thereof will be described below with reference to FIG. 8.

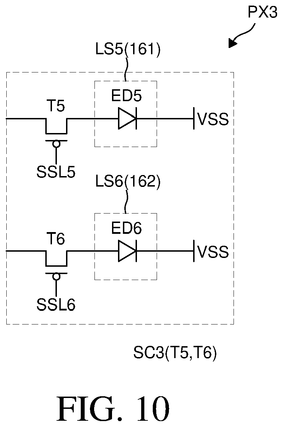

FIG. 8 is a circuit diagram illustrating an example of a first pixel of the display device according to an exemplary embodiment of the present disclosure. FIG. 9 is a circuit diagram illustrating an example of a second pixel of the display device according to an exemplary embodiment of the present disclosure. FIG. 10 is a circuit diagram illustrating an example of a third pixel of the display device according to an exemplary embodiment of the present disclosure.

FIG. 8 through FIG. 10 illustrate examples of a first pixel PX1, a second pixel PX2, and a third pixel PX3, respectively, included in the plurality of pixels PX disposed in the display panel PN of the display device 100 according to an exemplary embodiment of the present disclosure.

Each of the first pixel PX1, the second pixel PX2, and the third pixel PX3 illustrated in FIG. 8 through FIG. 10, respectively, may include the pixel circuit SPC described above with reference to FIG. 3 or the pixel circuit SPC_1 described above with reference to FIG. 4. Therefore, redundant description of the embodiment described above with reference to FIG. 3 and FIG. 4 will be omitted or briefly provided.

Also, FIG. 8 through FIG. 10 illustrate only a selection circuit, a plurality of light emitting didoes, and a plurality of lenses among the components included in the first pixel PX1, the second pixel PX2, and the third pixel PX3 for the convenience of description. Herein, as for the plurality of lenses, only a correspondence relationship is schematically illustrated by a dotted line for the convenience of description.

First, referring to FIG. 3, FIG. 4, and FIG. 8, the first pixel PX1 may include a first selection circuit SC1 and a plurality of light emitting diodes ED1 and ED2.

The first selection circuit SC1 may include a first transistor T1 and a second transistor T2. The first transistor T1 and the second transistor T2 of FIG. 8 may correspond to the first selection transistor TP1 and the second selection transistor TP2, respectively, described above with reference to FIG. 3 and FIG. 4.

A gate electrode of the first transistor T1 may be turned on or turned off in response to a selection signal supplied from a first selection signal line SSL1. In particular, the first transistor T1 may be turned on in response to the selection signal of a low level, and turned off in response to the selection signal of a high level. Also, a gate electrode of the second transistor T2 may be turned on or turned off in response to a selection signal supplied from a second selection signal line SSL2. In particular, the second transistor T2 may be turned on in response to the selection signal of a low level, and turned off in response to the selection signal of a high level. Herein, the selection signal supplied from the first selection signal line SSL1 and the selection signal supplied from the second selection signal line SSL2 may be the first selection signal Ss and the second selection signal Ps, respectively, described above with reference to FIG. 3 and FIG. 4. However, the present disclosure is not limited thereto.

The plurality of light emitting diodes ED1 and ED2 included in the first pixel PX1 may include a first light emitting diode ED1 and a second light emitting diode ED2. In substantially the same or similar manner as the embodiment described above with reference to FIG. 3 and FIG. 4, the first light emitting diode ED1 of the first pixel PX1 may be connected between the first transistor T1 which is turned on or turned off by the selection signal supplied from the first selection signal line SSL1 and the second power line which supplies the second power voltage VSS, e.g., a low-potential power voltage. Also, the second light emitting diode ED2 of the first pixel PX1 may be connected between the second transistor T2 which is turned on or turned off by the selection signal supplied from the second selection signal line SSL2 and the second power line which supplies the second power voltage VSS. For example, the first light emitting diode ED1 and the second light emitting diode ED2 of FIG. 8 may correspond to the first type light emitting diode EDa and the second type light emitting diode EDb, respectively, described above with reference to FIG. 3 and FIG. 4.

Therefore, when the first transistor T1 is turned on in response to a selection signal of a turn-on level supplied from the first selection signal line SSL1, a first driving current flowing through the first light emitting diode ED1 may be generated. Thus, the first light emitting diode ED1 of the first pixel PX1 may emit light.

Also, when the second transistor T2 is turned on in response to a selection signal of a turn-on level supplied from the second selection signal line SSL2, a second driving current flowing through the second light emitting diode ED2 may be generated. Thus, the second light emitting diode ED2 of the first pixel PX1 may emit light.

The first pixel PX1 may be driven in the first state in which the first light emitting diode ED1 emits light or in the third state in which both of the first light emitting diode ED1 and the second light emitting diode ED2 emit light, without being limited thereto.

The first pixel PX1 may include a first lens LS1 disposed on the first light emitting diode ED1 and a second lens LS2 disposed on the second light emitting diode ED2. For example, each of the first lens LS1 and the second lens LS2 may be implemented as the first type lens 161 described above with reference to FIG. 6. However, the present disclosure is not limited thereto.

Therefore, when the first driving current is generated in the first pixel PX1 and the first light emitting diode ED1 emits light, the light generated by the first light emitting diode ED1 of the first pixel PX1 is emitted through the first lens LS1 implemented as the first type lens 161. Thus, content supplied by the light generated by the first light emitting diode ED1 of the first pixel PX1 may be supplied at a first viewing angle.

Also, when the second driving current is generated in the first pixel PX1 and the second light emitting diode ED2 emits light, the light generated by the second light emitting diode ED2 of the first pixel PX1 is emitted through the second lens LS2 implemented as the first type lens 161. Thus, content supplied by the light generated by the second light emitting diode ED2 of the first pixel PX1 may be supplied at the first viewing angle.

That is, as for the first pixel PX1, both of the content supplied by the light generated by the first light emitting diode ED1 and the content supplied by the light generated by the second light emitting diode ED2 may be supplied at the first viewing angle.

Herein, as described above, the first pixel PX1 may be driven in the first state in which the first light emitting diode ED1 emits light or in the third state in which both of the first light emitting diode ED1 and the second light emitting diode ED2 emit light. Therefore, when the first pixel PX1 is driven in the first state, content supplied by light generated by the first light emitting diode ED1 may be supplied at the first viewing angle. Also, when the first pixel PX1 is driven in the third state, content supplied by light generated by the first light emitting diode ED1 and light generated by the second light emitting diode ED2 may be supplied at the first viewing angle.

Meanwhile, when the first pixel PX1 is driven in the third state compared to the first state in which only the first light emitting diode ED1 emits light, content may be supplied at the first viewing angle as in the first state. However, both of the first light emitting diode ED1 and the second light emitting diode ED2 emit light, and, thus, a luminance of the content may be increased. That is, when the same data signal is written and the first pixel PX1 is driven in the third state, a luminance may be higher compared to the case where the first pixel PX1 is driven in the first state.

Referring to FIG. 3, FIG. 4, and FIG. 9, the second pixel PX2 may include a second selection circuit SC2 and a plurality of light emitting diodes ED3 and ED4.

The second selection circuit SC2 may include a third transistor T3 and a fourth transistor T4. The third transistor T3 and the fourth transistor T4 of FIG. 9 may correspond to the first selection transistor TP1 and the second selection transistor TP2, respectively, described above with reference to FIG. 3 and FIG. 4.

A gate electrode of the third transistor T3 may be turned on or turned off in response to a selection signal supplied from a third selection signal line SSL3. In particular, the third transistor T3 may be turned on in response to the selection signal of a low level, and turned off in response to the selection signal of a high level. Also, a gate electrode of the fourth transistor T4 may be turned on or turned off in response to a selection signal supplied from a fourth selection signal line SSL4. In particular, the fourth transistor T4 may be turned on in response to the selection signal of a low level, and turned off in response to the selection signal of a high level. Herein, the selection signal supplied from the third selection signal line SSL3 and the selection signal supplied from the fourth selection signal line SSL4 may be the first selection signal Ss and the second selection signal Ps, respectively, described above with reference to FIG. 3 and FIG. 4. However, the present disclosure is not limited thereto.

The plurality of light emitting diodes ED3 and ED4 included in the second pixel PX2 may include a third light emitting diode ED3 and a fourth light emitting diode ED4. In substantially the same or similar manner as the embodiment described above with reference to FIG. 3 and FIG. 4, the third light emitting diode ED3 of the second pixel PX2 may be connected between the third transistor T3 which is turned on or turned off by the selection signal supplied from a third selection signal line SSL3 and the second power line which supplies the second power voltage VSS. Also, the fourth light emitting diode ED4 of the second pixel PX2 may be connected between the fourth transistor T4 which is turned on or turned off by the selection signal supplied from a fourth selection signal line SSL4 and the second power line which supplies the second power voltage VSS. For example, the third light emitting diode ED3 and the fourth light emitting diode ED4 of FIG. 9 may correspond to the first type light emitting diode EDa and the second type light emitting diode EDb, respectively, described above with reference to FIG. 3 and FIG. 4.

Therefore, when the third transistor T3 is turned on in response to a selection signal of a turn-on level supplied from the third selection signal line SSL3, a first driving current flowing through the third light emitting diode ED3 may be generated. Thus, the third light emitting diode ED3 of the second pixel PX2 may emit light.

Also, when the fourth transistor T4 is turned on in response to a selection signal of a turn-on level supplied from the fourth selection signal line SSL4, a second driving current flowing through the fourth light emitting diode ED4 may be generated. Thus, the fourth light emitting diode ED4 of the second pixel PX2 may emit light.

The second pixel PX2 may be driven in the first state in which the third light emitting diode ED3 emits light or in the third state in which both of the third light emitting diode ED3 and the fourth light emitting diode ED4 emit light, without being limited thereto.

The second pixel PX2 may include a third lens LS3 disposed on the third light emitting diode ED3 and a fourth lens LS4 disposed on the fourth light emitting diode ED4. For example, the third lens LS3 may be implemented as the first type lens 161 described above with reference to FIG. 6, and the fourth lens LS4 may be implemented as the second type lens 162 described above with reference to FIG. 7.

Therefore, when the first driving current is generated in the second pixel PX2 and the third light emitting diode ED3 emits light, the light generated by the third light emitting diode ED3 of the second pixel PX2 may be emitted through the third lens LS3 implemented as the first type lens 161. Thus, content supplied by the light generated by the third light emitting diode ED3 of the second pixel PX2 may be supplied at the first viewing angle.

Also, when the second driving current is generated in the second pixel PX2 and the fourth light emitting diode ED4 emits light, the light generated by the fourth light emitting diode ED4 of the second pixel PX2 may be emitted through the fourth lens LS4 implemented as the second type lens 162. Thus, content supplied by the light generated by the fourth light emitting diode ED4 of the second pixel PX2 may be supplied at a second viewing angle.

Herein, as described above, the second pixel PX2 may be driven in the first state in which the third light emitting diode ED3 emits light or in the third state in which both of the third light emitting diode ED3 and the fourth light emitting diode ED4 emit light, without being limited thereto. Therefore, when the second pixel PX2 is driven in the first state, content supplied by light generated by the third light emitting diode ED3 may be supplied at the first viewing angle. Also, when the second pixel PX2 is driven in the third state, content supplied by light generated by the third light emitting diode ED3 may be supplied at the first viewing angle and content supplied by light generated by the fourth light emitting diode ED4 may be supplied at the second viewing angle. Herein, even when content is supplied at the second viewing angle, content is also supplied at the first viewing angle. As a result, the user may be supplied with content at the first viewing angle. Therefore, when the second pixel PX2 is driven in the first state or in the third state, the user may be supplied with content at the first viewing angle.

Meanwhile, when the second pixel PX2 is driven in the third state compared to the first state in which only the third light emitting diode ED3 emits light, content may be supplied at the first viewing angle as in the first state. However, both of the third light emitting diode ED3 and the fourth light emitting diode ED4 emit light, and, thus, a luminance of the content may be increased. That is, when the same data signal is written and the second pixel PX2 is driven in the third state, a luminance may be higher compared to the case where the second pixel PX2 is driven in the first state.

Referring to FIG. 3, FIG. 4, and FIG. 10, the third pixel PX3 may include a third selection circuit SC3 and a plurality of light emitting diodes ED5 and ED6.

The third selection circuit SC3 may include a fifth transistor T5 and a sixth transistor T6. The fifth transistor T5 and the sixth transistor T6 of FIG. 10 may correspond to the first selection transistor TP1 and the second selection transistor TP2, respectively, described above with reference to FIG. 3 and FIG. 4.

A gate electrode of the fifth transistor T5 may be turned on or turned off in response to a selection signal supplied from a fifth selection signal line SSL5. In particular, the fifth transistor T5 may be turned on in response to the selection signal of a low level, and turned off in response to the selection signal of a high level. Also, a gate electrode of the sixth transistor T6 may be turned on or turned off in response to a selection signal supplied from a sixth selection signal line SSL6. In particular, the sixth transistor T6 may be turned on in response to the selection signal of a low level, and turned off in response to the selection signal of a high level. Herein, the selection signal supplied from the fifth selection signal line SSL5 and the selection signal supplied from the sixth selection signal line SSL6 may be the first selection signal Ss and the second selection signal Ps, respectively, described above with reference to FIG. 3 and FIG. 4. However, the present disclosure is not limited thereto.

The plurality of light emitting diodes ED5 and ED6 included in the third pixel PX3 may include a fifth light emitting diode ED5 and a sixth light emitting diode ED6. In substantially the same or similar manner as the embodiment described above with reference to FIG. 3 and FIG. 4, the fifth light emitting diode ED5 of the third pixel PX3 may be connected between the fifth transistor T5 which is turned on or turned off by the selection signal supplied from the fifth selection signal line SSL5 and the second power line which supplies the second power voltage VSS. Also, the sixth light emitting diode ED6 of the third pixel PX3 may be connected between the sixth transistor T6 which is turned on or turned off by the selection signal supplied from the sixth selection signal line SSL6 and the second power line which supplies the second power voltage VSS. For example, the fifth light emitting diode ED5 and the sixth light emitting diode ED6 of FIG. 10 may correspond to the first type light emitting diode EDa and the second type light emitting diode EDb, respectively, described above with reference to FIG. 3 and FIG. 4.

Therefore, when the fifth transistor T5 is turned on in response to a selection signal of a turn-on level supplied from the fifth selection signal line SSL5, a first driving current flowing through the fifth light emitting diode ED5 may be generated. Thus, the fifth light emitting diode ED5 of the third pixel PX3 may emit light.

Also, when the sixth transistor T6 is turned on in response to a selection signal of a turn-on level supplied from the sixth selection signal line SSL6, a second driving current flowing through the sixth light emitting diode ED6 may be generated. Thus, the sixth light emitting diode ED6 of the third pixel PX3 may emit light.

The third pixel PX3 may be driven in the first state in which the fifth light emitting diode ED5 emits light or in the second state in which the sixth light emitting diode ED6 emits light, without being limited thereto.

The third pixel PX3 may include a fifth lens LS5 disposed on the fifth light emitting diode ED5 and a sixth lens LS6 disposed on the sixth light emitting diode ED6. For example, the fifth lens LS5 may be implemented as the first type lens 161 described above with reference to FIG. 6, and the sixth lens LS6 may be implemented as the second type lens 162 described above with reference to FIG. 7, without being limited thereto.

That is, the third pixel PX3 may have substantially the same structure as the second pixel PX2. For example, the third pixel PX3 may have a lens structure including the first type lens 161 disposed on the fifth light emitting diode ED5 and the second type lens 162 disposed on the sixth light emitting diode ED6.

Therefore, when the first driving current is generated in the third pixel PX3 and the fifth light emitting diode ED5 emits light, the light generated by the fifth light emitting diode ED5 of the third pixel PX3 is emitted through the fifth lens LS5 implemented as the first type lens 161. Thus, content supplied by the light generated by the fifth light emitting diode ED5 of the third pixel PX3 may be supplied at the first viewing angle.

Also, when the second driving current is generated in the third pixel PX3 and the sixth light emitting diode ED6 emits light, the light generated by the sixth light emitting diode ED6 of the third pixel PX3 is emitted through the sixth lens LS6 implemented as the second type lens 162. Thus, content supplied by the light generated by the sixth light emitting diode ED6 of the third pixel PX3 may be supplied at the second viewing angle.

Herein, as described above, the third pixel PX3 may be driven in the first state in which the fifth light emitting diode ED5 emits light or in the second state in which the sixth light emitting diode ED6 emits light, without being limited thereto. Therefore, when the third pixel PX3 is driven in the first state, content supplied by light generated by the fifth light emitting diode ED5 may be supplied at the first viewing angle. Also, when the third pixel PX3 is driven in the second state, content supplied by light generated by the sixth light emitting diode ED6 may be supplied at the second viewing angle.

As described, even when the second pixel PX2 has the same lens structure as the third pixel PX3, the second pixel PX2 and the third pixel PX3 may supply content by different driving methods from each other in response to selection signals respectively supplied from the third and fourth selection signal lines SSL3 and SSL4 of the second pixel PX2 and the fifth and sixth selection signal lines SSL5 and SSL6 of the third pixel PX3. For example, since the second pixel PX2 is driven in the first state or in the third state as described above, the second pixel PX2 may supply content only in the share mode. Also, since the third pixel PX3 is driven in the first state or in the second state, the third pixel PX3 may supply content in the share mode or content in the private mode. However, the present disclosure is not limited thereto.

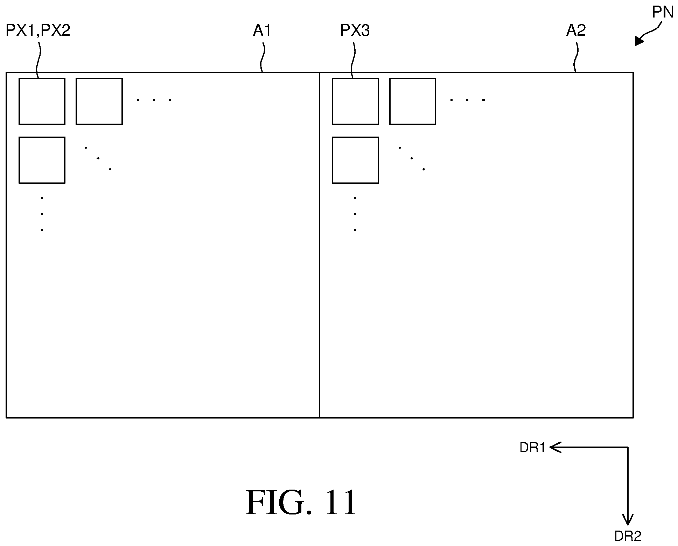

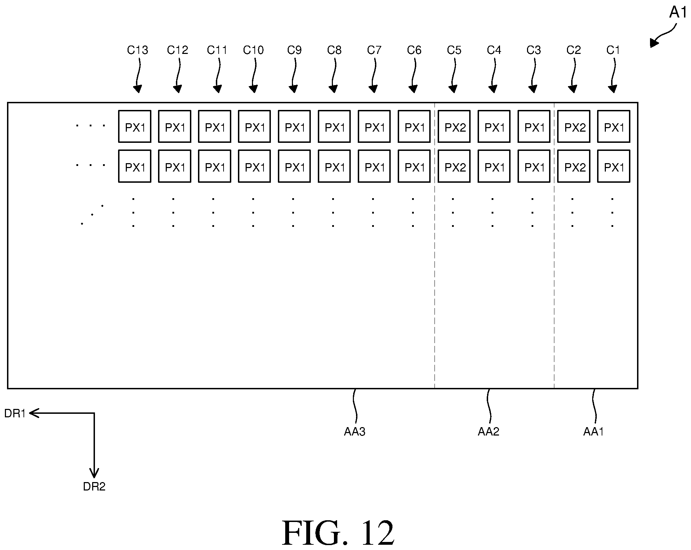

FIG. 11 illustrates an example of a display panel of the display device according to an exemplary embodiment of the present disclosure. FIG. 12 illustrates an example of a first area of the display panel of FIG. 11.

Meanwhile, FIG. 11 illustrates an example of the display panel PN included in the display device 100 according to an exemplary embodiment of the present disclosure of FIG. 1 and FIG. 2 and including a plurality of areas such as first and second areas A1 and A2, but is not limited thereto. FIG. 12 illustrates an example of the first area A1 included in the display panel PN of FIG. 11.

FIG. 11 and FIG. 12 are plan views illustrating a horizontal direction as a first direction DR1 and a vertical direction as a second direction DR2 for the convenience of description.

Referring to FIG. 2 and FIG. 11, the display panel PN may be divided into a plurality of areas A1 and A2. For example, as shown in FIG. 11, the display panel PN may be divided into two areas A1 and A2. For example, the display panel PN may include the first area A1 and the second area A2 adjacent to the first area A1 in a direction opposite to the first direction DR1.

Each of the areas A1 and A2 included in the display panel PN may include a plurality of pixels each including a pixel circuit. For example, a plurality of first pixels PX1 and a plurality of second pixels PX2 may be disposed to be spaced apart from each other along the first direction DR1 and the second direction DR2 in the first area A1. Also, a plurality of third pixels PX3 may be disposed to be spaced part from each other along the first direction DR1 and the second direction DR2 in the second area A2. However, the present disclosure is not limited thereto.

The disposition of the plurality of first pixels PX1 and the plurality of second pixels PX2 in the first area A1 will be described in more detail with reference to FIG. 12. The first area A1 of the display panel PN may include first to third sub-areas AA1 to AA3 sequentially disposed along the first direction DR1. For example, the second sub-area AA2 may be disposed adjacent to the first sub-area AA1 along the first direction DR1. Also, the third sub-area AA3 may be disposed adjacent to the second sub-area AA2 along the first direction DR1. Also, the second sub-area AA2 may be disposed between the first sub-area AA1 and the third sub-area AA3, but is not limited thereto.

Referring to FIG. 11 and FIG. 12, the first and second sub-areas AA1 and AA2 of the first area A1 may be defined as a portion of the first area A1 adjacent to the second area A2. Also, the third sub-area AA3 may be defined as the other portion of the first area A1 except the first and second sub-areas AA1 and AA2. Herein, the first and second sub-areas AA1 and AA2 shown in FIG. 12 are merely an example of a portion of the first area A1 adjacent to the second area A2, without being limited thereto. Further, the portion of the first area A1 adjacent to the second area A2 may be set variously depending on the design of the display panel PN.

Each of the first to third sub-areas AA1 to AA3 may include a plurality of pixels, e.g., the first pixel PX1 and/or the second pixel PX2, disposed to be spaced apart from each other along the first direction DR1 and the second direction DR2, without being limited thereto.

The first to third sub-areas AA1 to AA3 may have different densities (or pixel densities) of second pixels PX2. That is, the second pixels PX2 may be disposed at different densities (or pixel densities) in the first to third sub-areas AA1 to AA3.

The proportion, e.g., the pixel density, of second pixels PX2 per unit area may gradually decrease in the first direction DR1 within the first area A1. For example, the proportion of second pixels PX2 per unit area may gradually decrease in a direction from the first sub-area AA1 to the third sub-area AA3, i.e., with distance from a boundary between the first area A1 and the second area A2 within the first area A1.

For example, a plurality of first pixels PX1 and a plurality of second pixels PX2 may be disposed in the first sub-area AA1, and the plurality of second pixels PX2 may be disposed at a first pixel density in the first sub-area AA1.

Also, a plurality of first pixels PX1 and a plurality of second pixels PX2 may be disposed in the second sub-area AA2. Further, the plurality of second pixels PX2 may be disposed in the second sub-area AA2 at a second pixel density lower than the first pixel density in the first sub-area AA1.

Furthermore, only a plurality of first pixels PX1 may be disposed in the third sub-area AA3. In other words, any second pixel PX2 is not disposed in the third sub-area AA3. Therefore, a third pixel density of second pixels PX2 in the third sub-area AA3 may be lower than the second pixel density of second pixels PX2 in the second sub-area AA2, and the third pixel density of second pixels PX2 in the third sub-area AA3 may be zero (0), but is not limited thereto.

Herein, the density or pixel density may be defined as the proportion (%) of an area in which pixels are disposed to a corresponding total area. Alternatively, the density or pixel density may be defined as the proportion (%) of an area in which pixels are disposed to a predetermined unit area. The area in which pixels are disposed may be a total sum of respective areas of the pixels, but is not limited thereto.

Meanwhile, the area of each pixel may refer to the area of a region including a pixel circuit and a light emitting diode. For example, the area of each pixel may refer to the area of an emission surface of the light emitting diode. As another example, if each pixel includes an organic light emitting diode, the area of the pixel may refer to the area of an anode exposed between pixel defining films or the area of an emission layer.

Alternatively, the density or pixel density may be defined as a total number of pixels to a corresponding total area (pixel per inch (PPI)), or a total number of pixels to a predetermined unit area (pixel per inch (PPI)).

More specifically, referring to FIG. 12, the first sub-area AA1 of the first area A1 may include a first column C1 and a second column C2, but is not limited thereto. In particular, the first sub-area AA1 of the first area A1 may include a plurality of first pixels PX1 sequentially disposed along the second direction DR2 in the first column C1. Also, the first sub-area AA1 of the first area A1 may include a plurality of second pixels PX2 sequentially disposed along the second direction DR2 in the second column C2 adjacent to the first column C1 in the first direction DR1. As such, the plurality of second pixels PX2 may be disposed in the second column C2, which is one of the two columns C1 and C2, and the plurality of first pixels PX1 may be disposed in the first column C1, which is the other column. In this case, the plurality of second pixels PX2 may be defined as being disposed at the first pixel density in the first sub-area AA1.

Further, the second sub-area AA2 of the first area A1 may include a third column C3, a fourth column C4 and a fifth column C5, but is not limited thereto. In particular, the second sub-area AA2 of the first area A1 may include a plurality of first pixels PX1 sequentially disposed along the second direction DR2 in each of the third column C3 adjacent to the second column C2 in the first direction DR1 and the fourth column C4 adjacent to the third column C3 in the first direction DR1. Furthermore, the second sub-area AA2 of the first area A1 may include a plurality of second pixels PX2 sequentially disposed along the second direction DR2 in the fifth column C5 adjacent to the fourth column C4 in the first direction DR1. As such, the plurality of second pixels PX2 may be disposed in the fifth column C5, which is one of the three columns C3, C4 and C5, and the plurality of first pixels PX1 may be disposed in the third and fourth columns C3 and C4, which are the other columns, but is not limited thereto. In this case, the plurality of second pixels PX2 may be defined as being disposed at the second pixel density in the second sub-area AA2. Herein, as described above, the second pixel density in the second sub-area AA2 may be lower than the first pixel density in the first sub-area AA1.

Also, only a plurality of first pixels PX1 may be disposed in the third sub-area AA3 of the first area A1 except the first and second sub-areas AA1 and AA2 in which the second pixels PX2 are disposed. For example, a plurality of first pixels PX1 may be sequentially disposed along the second direction DR2 in a plurality of columns including a sixth column C6 adjacent to the fifth column C5 in the first direction DR1, a seventh column C7 adjacent to the sixth column C6 in the first direction DR1, an eighth column C8 adjacent to the seventh column C7 in the first direction DR1, a ninth column C9 adjacent to the eighth column C8 in the first direction DR1, a tenth column C10 adjacent to the ninth column C9 in the first direction DR1, an eleventh column C11 adjacent to the tenth column C10 in the first direction DR1, a twelfth column C12 adjacent to the eleventh column C11 in the first direction DR1, a thirteenth column C13 adjacent to the twelfth column C12 in the first direction DR1 in the third sub-area AA3, and the like. As such, when only the plurality of first pixels PX1 is disposed in the plurality of columns, the second pixels PX2 may be defined as being disposed at the third pixel density in the third sub-area AA3. For example, the third pixel density in the third sub-area AA3 may be lower than the second pixel density in the second sub-area AA2 which is lower than the first pixel density in the first sub-area AA1, and the third pixel density may have a value of substantially zero (0), but is not limited thereto.

Meanwhile, as described above, the first area A1 of the display panel PN is disposed on the driver seat side in the vehicle as described above with reference to FIG. 1 and may supply content in the share mode. Also, the second area A2 of the display panel PN is disposed on the front passenger seat side in the vehicle as described above with reference to FIG. 1 and may supply content in the share mode or in the private mode depending on a driving mode of the display device 100.

For example, as described above, the first pixel PX1 and the second pixel PX2 driven in the first state or third state may be disposed in the first area A1 of the display panel PN and may supply the user with content at the first viewing angle. Also, the third pixel PX3 driven in the first state or second state may be disposed in the second area A2 of the display panel PN and may supply the user with content at the first viewing angle or second viewing angle. However, the present disclosure is not limited thereto.

As in the display device 100 according to an exemplary embodiment of the present disclosure, the first pixel PX1 including only the first type lens 161 is disposed in the first area A1 which supplies content at the first viewing angle. Also, the second pixel PX2 having the same lens structure as the third pixel PX3 disposed in the second area A2, i.e., including the first type lens 161 and the second type lens 162 is disposed in the first area A1. Therefore, it is possible to reduce or minimize visibility of the boundary between the first area A1 and the second area A2. However, the present disclosure is not limited thereto.

More specifically, in a comparative example of the present disclosure unlike the display device 100 according to an exemplary embodiment of the present disclosure, the second pixel PX2 is not disposed in the first area A1, but only the first pixel PX1 including the first type lens 161 only is disposed in the first area A1. Also, in the comparative example, the third pixel PX3 including the first type lens 161 and the second type lens 162 is disposed in the second area A2. As described above with reference to FIG. 6 and FIG. 7, the first type lens 161 has a different shape from the second type lens 162. Thus, the size of the first emission area exposed by the first type lens 161 may be different from the size of the second emission area exposed by the second type lens 162, and the boundary between the first area A1 and the second area A2 may be visible. For example, even when the pixels disposed in the display panel do not display any image in a power-off state, the boundary between the first area A1 and the second area A2 may be visible due to the reflection of external light. As another example, when the pixels disposed in the display panel display an image in the private mode in a power-on state, the boundary between the first area A1 and the second area A2 may be visible due to a difference in size of the emission area as described above.

However, in the display device 100 according to an exemplary embodiment of the present disclosure, the first area A1 of the display panel PN which supplies content at the first viewing angle includes not only the first pixel PX1, but also the second pixel PX2 having the same lens structure as the third pixel PX3 disposed in the second area A2. Therefore, it is possible to reduce or minimize visibility of the boundary between the first area A1 and the second area A2.

Hereinafter, an example where the display panel PN is driven depending on a driving mode of the display device 100 will be described in more detail with reference to FIG. 13A through FIG. 15.

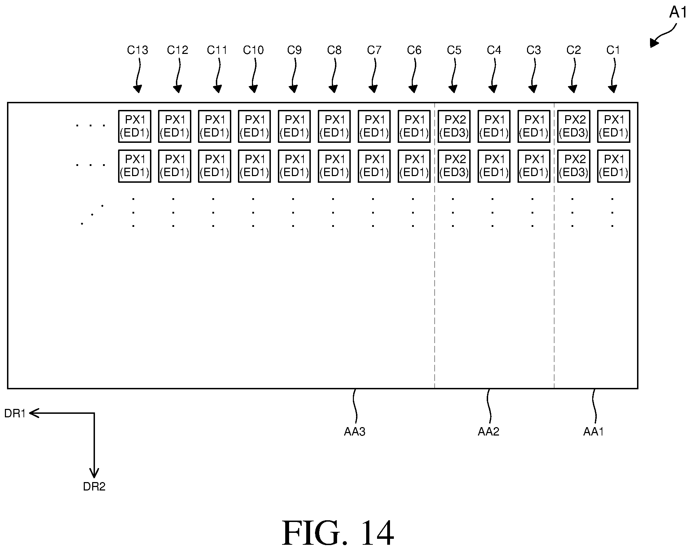

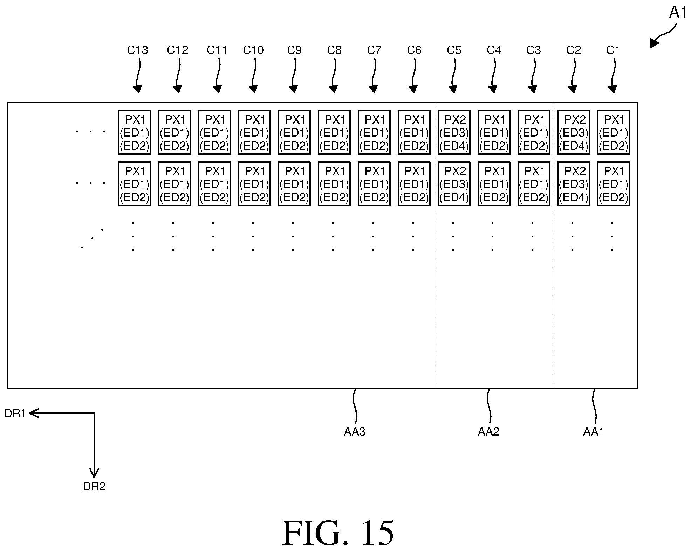

FIG. 13A illustrates an example where the display device according to an exemplary embodiment of the present disclosure is driven in the first mode. FIG. 13B illustrates an example where the display device according to an exemplary embodiment of the present disclosure is driven in the second mode. FIG. 14 illustrates an example where the first area of FIG. 12 is driven. FIG. 15 illustrates another example where the first area of FIG. 12 is driven.

Meanwhile, FIG. 13A and FIG. 13B illustrate examples of the second area A2 when the display device 100 according to an exemplary embodiment of the present disclosure is driven in the first mode and the second mode, respectively.

Referring to FIG. 2 through FIG. 12, the mode controller MS included in the display device 100 may generate the mode selection signal MSS based on a mode signal input from the outside. For example, the mode controller MS may receive a mode signal from the outside depending on a driving mode of the display device 100 and generate the mode selection signal MSS based on the mode signal. Then, the mode controller MS may supply the mode selection signal MSS to the mode selection unit MD. Further, the mode selection unit MD may supply a plurality of pixels PX with a selection signal corresponding to the driving mode in response to the mode selection signal MSS supplied from the mode controller MS. For example, the plurality of pixels PX may include a plurality of first pixels PX1 and a plurality of second pixels PX2 disposed in the first area A1, and a plurality of third pixels PX3 disposed in the second area A2. However, the present disclosure is not limited thereto.

When the display device 100 is driven in the first mode, the second area A2 of the display panel PN may supply the user with content at the first viewing angle in response to a selection signal supplied from the mode selection unit MD.

Specifically, referring to FIG. 13A, when the display device 100 is driven in the first mode, each of the plurality of third pixels PX3 disposed in the second area A2 may be driven in the first state.

For example, in the first mode, the fifth transistor T5 included in the third pixel PX3 may be turned on in response to a selection signal supplied through the fifth selection signal line SSL5. In particular, the fifth transistor T5 may be turned on in response to the selection signal of a low level, and turned off in response to the selection signal of a high level. Also, a first driving current may be generated in the third pixel PX3, and light generated from the fifth light emitting diode ED5 of the third pixel PX3 by the first driving current is emitted through the fifth lens LS5 configured as the first type lens 161. Thus, content may be supplied at the first viewing angle.

Meanwhile, in the first mode, a selection signal maintained at a turn-off level is supplied through the sixth selection signal line SSL6. Thus, the sixth transistor T6 included in the third pixel PX3 may be maintained in a turn-off state and the sixth light emitting diode ED6 of the third pixel PX3 may be maintained in a non-emission state.

Also, when the display device 100 is driven in the second mode, the second area A2 of the display panel PN may supply the user with content at the second viewing angle in response to a selection signal supplied from the mode selection unit MD.

Specifically, referring to FIG. 13B, when the display device 100 is driven in the second mode, each of the plurality of third pixels PX3 disposed in the second area A2 may be driven in the second state.

For example, in the second mode, the sixth transistor T6 included in the third pixel PX3 may be turned on in response to a selection signal supplied through the sixth selection signal line SSL6. In particular, the sixth transistor T6 may be turned on in response to the selection signal of a low level, and turned off in response to the selection signal of a high level. Also, a second driving current may be generated in the third pixel PX3, and light generated from the sixth light emitting diode ED6 of the third pixel PX3 by the second driving current is emitted through the sixth lens LS6 configured as the second type lens 162. Thus, content may be supplied at the second viewing angle.

Meanwhile, in the second mode, a selection signal maintained at a turn-off level is supplied through the fifth selection signal line SSL5. Thus, the fifth transistor T5 included in the third pixel PX3 may be maintained in a turn-off state and the fifth light emitting diode ED5 of the third pixel PX3 may be maintained in a non-emission state.

Therefore, when the display device 100 is driven in the first mode, the second area A2 of the display panel PN may supply the user with content at the first viewing angle. Also, when the display device 100 is driven in the second mode, the second area A2 of the display panel PN may supply the user with content at the second viewing angle.

Also, as described above, the first area A1 of the display panel PN may be driven to supply content at the first viewing angle in both of the first mode in which content is supplied in the share mode and the second mode in which content is supplied in the private mode.

For example, when the display device 100 is driven in the first mode or the second mode, the first area A1 of the display panel PN may supply the user with content at the first viewing angle in response to a selection signal supplied from the mode selection unit MD, without being limited thereto.

Specifically, referring to FIG. 14, in each of the first mode and the second mode, the first area A1, e.g., each of a plurality of first pixels PX1 and a plurality of second pixels PX2 disposed in the first to third sub-areas AA1 to AA3, may be driven in the first state.

For example, in each of the first mode and the second mode, the first transistor T1 included in the first pixel PX1 may be turned on in response to a selection signal supplied through the first selection signal line SSL1. Then, a first driving current may be generated in the first pixel PX1 and the first light emitting diode ED1 of the first pixel PX1 emits light. Further, the third transistor T3 included in the second pixel PX2 may be turned on in response to a selection signal supplied through the third selection signal line SSL3. Then, a first driving current may be generated in the second pixel PX2 and the third light emitting diode ED3 of the second pixel PX2 emits light. Furthermore, light generated from the first light emitting diode ED1 of the first pixel PX1 by the first driving current is emitted through the first lens LS1 configured as the first type lens 161. Also, light generated from the third light emitting diode ED3 of the second pixel PX2 by the first driving current is emitted through the third lens LS3 configured as the first type lens 161. Thus, content may be supplied at the first viewing angle.

In this case, selection signals maintained at a turn-off level are supplied through the second selection signal line SSL2 and the fourth selection signal SSL4, respectively. Thus, the second transistor T2 included in the first pixel PX1 and the fourth transistor T4 included in the second pixel PX2 may be maintained in a turn-off state and. Therefore, the second light emitting diode ED2 of the first pixel PX1 and the fourth light emitting diode ED4 of the second pixel PX2 may be maintained in a non-emission state.

However, the method of driving the first area A1 for supplying content in the share mode in each of the first mode and the second mode is not limited thereto.

For example, referring to FIG. 15, as described above, in each of the first mode and the second mode, the first area A1, e.g., each of a plurality of first pixels PX1 and a plurality of second pixels PX2 disposed in the first to third sub-areas AA1 to AA3, may be driven in the third state.

For example, in each of the first mode and the second mode, the first transistor T1 included in the first pixel PX1 may be turned on in response to a selection signal supplied through the first selection signal line SSL1. Then, a first driving current may be generated in the first pixel PX1 and the first light emitting diode ED1 of the first pixel PX1 emits light. Further, the third transistor T3 included in the second pixel PX2 may be turned on in response to a selection signal supplied through the third selection signal line SSL3. Then, a first driving current may be generated in the second pixel PX2 and the third light emitting diode ED3 of the second pixel PX2 emits light. Furthermore, light generated from the first light emitting diode ED1 of the first pixel PX1 by the first driving current is emitted through the first lens LS1 configured as the first type lens 161. Also, light generated from the third light emitting diode ED3 of the second pixel PX2 by the first driving current is emitted through the third lens LS3 configured as the first type lens 161. Thus, content may be supplied at the first viewing angle.

Besides, in each of the first mode and the second mode, the second transistor T2 included in the first pixel PX1 may be turned on in response to a selection signal supplied through the second selection signal line SSL2. Then, a second driving current may be generated in the first pixel PX1 and the second light emitting diode ED2 of the first pixel PX1 emits light. Further, the fourth transistor T4 included in the second pixel PX2 may be turned on in response to a selection signal supplied through the fourth selection signal line SSL4. Then, a second driving current may be generated in the second pixel PX2 and the fourth light emitting diode ED4 of the second pixel PX2. Furthermore, light generated from the second light emitting diode ED2 of the first pixel PX1 by the second driving current is emitted through the second lens LS2 configured as the first type lens 161. Also, light generated from the fourth light emitting diode ED4 of the second pixel PX2 by the second driving current is emitted through the fourth lens LS4 configured as the second type lens 162. Thus, content may be supplied at the second viewing angle.

That is, according to the embodiment shown in FIG. 15, in each of the first mode and the second mode, the first pixel PX1 may be driven in the third state. Thus, both of the first light emitting diode ED1 and the second light emitting diode ED2 may emit light. Also, the second pixel PX2 may be driven in the third state. Thus, both of the third light emitting diode ED3 and the fourth light emitting diode ED4 may emit light. Herein, as described above, content may be supplied at the first viewing angle by light generated from the first light emitting diode ED1 of the first pixel PX1 and light generated from the second light emitting diode ED2. Therefore, the user may be supplied with content in the share mode from the first pixel PX1. Further, content may be supplied at the first viewing angle by light generated from the third light emitting diode ED3 of the second pixel PX2, and content may be supplied at the second viewing angle by light generated from the fourth light emitting diode ED4. Herein, even when content is supplied at the second viewing angle, content is also supplied at the first viewing angle. As a result, the user may be supplied with content in the share mode from the second pixel PX2.

In the above-described embodiment shown in FIG. 15 as in the embodiment shown in FIG. 14, the display device 100 can display content at the first viewing angle in the first area A1 of the display panel PN in each of the first mode and the second mode. Also, in the embodiment shown in FIG. 15 unlike the embodiment shown in FIG. 14, the light emitting diodes ED1 and ED2 of the first pixel PX1 and the light emitting diodes ED3 and ED4 of the second pixel PX2 emit light. Therefore, a luminance of the content may be increased. That is, when the same data signal is written and the first pixel PX1 and the second pixel PX2 are driven in the third state as shown in FIG. 15, a luminance may be higher compared to the case where the first pixel PX1 and the second pixel PX2 are driven in the first state. Therefore, it is possible to reduce or minimize power consumption for increasing a luminance.

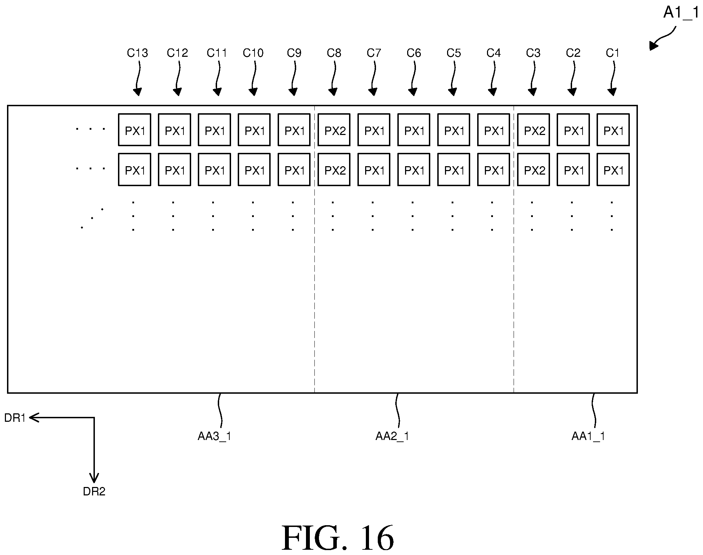

FIG. 16 illustrates another example of the first area of the display panel of FIG. 11.

FIG. 16 illustrates a modification example of the exemplary embodiment of FIG. 12 in association with a pixel density of second pixels PX disposed in a first area A1_1. Therefore, in FIG. 16, portions different from those of the above-described exemplary embodiments will be mainly described to avoid redundancy.

FIG. 16 illustrates an example of the first area A1_1 included in the display panel PN of FIG. 11.

Referring to FIG. 16, the first area A1_1 of the display panel PN may include a plurality of areas such as first to third sub-areas AA1_1, AA2_1 and AA3_1 sequentially disposed along the first direction DR1. For example, the second sub-area AA2_1 may be disposed adjacent to the first sub-area AA1_1 along the first direction DR1. Also, the third sub-area AA3_1 may be disposed adjacent to the second sub-area AA2_1 along the first direction DR1. Also, the second sub-area AA2_1 may be disposed between the first sub-area AA1_1 and the third sub-area AA3_1, but is not limited thereto.

Referring to FIG. 11 and FIG. 16, the first and second sub-areas AA1_1 and AA2_1 of the first area A1_1 may be defined as a portion of the first area A1_1 adjacent to the second area A2. Also, the third sub-area AA3_1 may be defined as the other portion of the first area A1_1 except the first and second sub-areas AA1_1 and AA2_1. Herein, the first and second sub-areas AA1_1 and AA2_1 shown in FIG. 16 are merely an example of a portion of the first area A1_1 adjacent to the second area A2. The portion of the first area A1_1 adjacent to the second area A2 may be set variously depending on the design of the display panel PN.

Each of the first to third sub-areas AA1_1 to AA3 _1 may include a plurality of pixels disposed to be spaced apart from each other along the first direction DR1 and the second direction DR2. However, the present disclosure is not limited thereto.

The first to third sub-areas AA1_1 to AA3_1 may have different densities of second pixels PX2. That is, the second pixels PX2 may be disposed at different densities in the first to third sub-areas AA1_1 to AA3_1.

The proportion of second pixels PX2 per unit area may gradually decrease in the first direction DR1 within the first area A1_1. For example, the proportion of second pixels PX2 per unit area may gradually decrease in a direction from the first sub-area AA1_1 to the third sub-area AA3_1, i.e., with distance from a boundary between the first area A1_1 and the second area A2 within the first area A1_1.

For example, a plurality of first pixels PX1 and a plurality of second pixels PX2 may be disposed in the first sub-area AA1_1, and the plurality of second pixels PX2 may be disposed at the first pixel density in the first sub-area AA1_1.

Also, a plurality of first pixels PX1 and a plurality of second pixels PX2 may be disposed in the second sub-area AA2_1. Further, the plurality of second pixels PX2 may be disposed in the second sub-area AA2_1 at the second pixel density lower than the first pixel density in the first sub-area AA1_1.

Furthermore, only a plurality of first pixels PX1 may be disposed in the third sub-area AA3_1. In other words, any second pixel PX2 is not disposed in the third sub-area AA3_1. Therefore, the third pixel density of second pixels PX2 in the third sub-area AA3_1 may be zero (0), but is not limited thereto.

The first sub-area AA1_1 of the first area A1_1 may include a plurality of columns. Also, the first sub-area AA1_1 of the first area A1_1 may include a plurality of second pixels PX2 sequentially disposed along the second direction DR2 in one column, and a plurality of first pixels PX1 sequentially disposed along the second direction DR2 in the remaining columns other than the one column. More specifically, referring to FIG. 16, the first sub-area AA1_1 of the first area A1_1 may include the plurality of first pixels PX1 sequentially disposed along the second direction DR2 in each of the first column C1 and the second column C2. Also, the first sub-area AA1_1 of the first area A1_1 may include the plurality of second pixels PX2 sequentially disposed along the second direction DR2 in the third column C3. As such, the plurality of second pixels PX2 may be disposed in the third column C3, which is one of the three columns C1, C2 and C3, and the plurality of first pixels PX1 may be disposed in the first column C1 and the second column C2, which are the other columns. In this case, the plurality of second pixels PX2 may be defined as being disposed at the first pixel density in the first sub-area AA1_1.

Further, the second sub-area AA2_1 of the first area A1_1 may include a plurality of columns. Also, the second sub-area AA2_1 of the first area A1_1 may include a plurality of second pixels PX2 sequentially disposed along the second direction DR2 in one column, and a plurality of first pixels PX1 sequentially disposed along the second direction DR2 in the remaining columns other than the one column. The number of columns in the first sub-area AA1_1 is less than the number of columns in the second sub-area AA2_1. More specifically, the second sub-area AA2_1 of the first area A1_1 may include a plurality of first pixels PX1 sequentially disposed along the second direction DR2 in each of the fourth column C4, the fifth column C5, the sixth column C6, and the seventh column C7. Furthermore, the second sub-area AA2_1 of the first area A1_1 may include a plurality of second pixels PX2 sequentially disposed along the second direction DR2 in the eighth column C8. As such, the plurality of second pixels PX2 may be disposed in the eighth column C8, which is one of the five columns C4, C5, C6, C7 and C8, and the plurality of first pixels PX1 may be disposed in the fourth to seventh columns C4, C5, C6 and C7, which are the other columns. In this case, the plurality of second pixels PX2 may be defined as being disposed at the second pixel density in the second sub-area AA2_1. Herein, as described above, the second pixel density in the second sub-area AA2_1 may be lower than the first pixel density in the first sub-area AA1_1.

Also, only a plurality of first pixels PX1 may be disposed in the third sub-area AA3_1 of the first area A1_1 except the first and second sub-areas AA1_1 and AA2_1 in which the second pixels PX2 are disposed. For example, a plurality of first pixels PX1 may be sequentially disposed along the second direction DR2 in a plurality of columns including the ninth column C9, the tenth column C10, the eleventh column C11, the twelfth column C12, the thirteenth column C13 and the like in the third sub-area AA3_1. As such, when only the plurality of first pixels PX1 is disposed in the plurality of columns, the second pixels PX2 may be defined as being disposed at the third pixel density in the third sub-area AA3_1. For example, the third pixel density in the third sub-area AA3_1 may be lower than the second pixel density in the second sub-area AA2_1 which is lower than the first pixel density in the first sub-area AA1_1, and the third pixel density may have a value of substantially zero (0), but is not limited thereto.

Meanwhile, when the display device 100 is driven in the first mode or the second mode, each of the plurality of first pixels PX1 and the plurality of second pixels PX2 disposed in the first area A1_1 of the display panel PN may be driven in the first state or the third state.

For example, as described above with reference to FIG. 14, when each of the plurality of first pixels PX1 and the plurality of second pixels PX2 disposed in the first area A1_1 of the display panel PN is driven in the first state, the first light emitting diode ED1 included in each of the plurality of first pixels PX1 disposed in the first area A1_1 emits light. Thus, content may be supplied at the first viewing angle. Also, the third light emitting diode ED3 included in each of the plurality of second pixels PX2 emits light. Thus, content may be supplied at the first viewing angle.

Also, as described above with reference to FIG. 15, when each of the plurality of first pixels PX1 and the plurality of second pixels PX2 disposed in the first area A1_1 is driven in the third state, both of the first light emitting diode ED1 and the second light emitting diode ED2 included in each of the plurality of first pixels PX1 disposed in the first area A1_1 emit light. Thus, content may be supplied at the first viewing angle. Further, both of the third light emitting diode ED3 and the fourth light emitting diode ED4 included in each of the plurality of second pixels PX2 emit light. Thus, content may be supplied at the first viewing angle.

When the display device 100 is driven in the first mode or the second mode, each of the plurality of first pixels PX1 and the plurality of second pixels PX2 disposed in the first area A1_1 of the display panel PN may be driven in the first state or the third state and content may be supplied at the first viewing angle in the first area A1_1. This driving method is substantially the same or similar to the driving method by which each of the plurality of first pixels PX1 and the plurality of second pixels PX2 disposed in the first area A1 is driven in the first state or the third state and content is supplied at the first viewing angle in the first area A1, as described above with reference to FIG. 14 and FIG. 15. Therefore, redundant description thereof will be omitted or briefly provided.

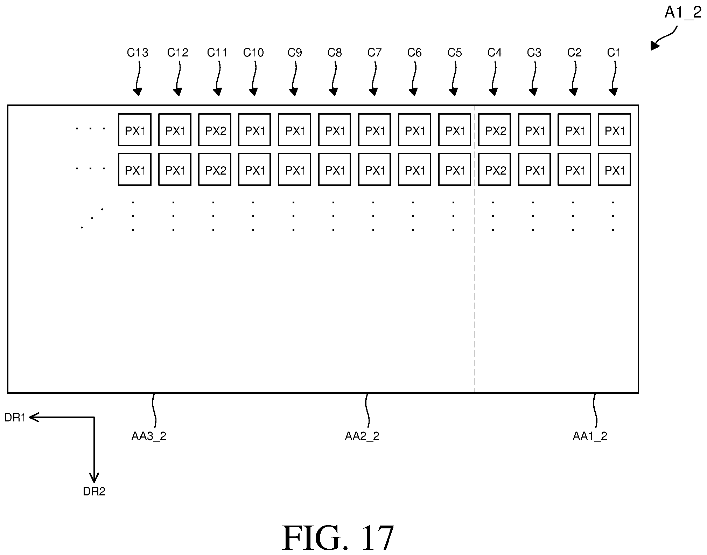

FIG. 17 illustrates yet another example of a first area of the display panel of FIG. 11.

FIG. 17 illustrates a modification example of the exemplary embodiment of FIG. 12 in association with a pixel density of second pixels PX disposed in a first area A1_2. Therefore, in FIG. 17, portions different from those of the above-described exemplary embodiments will be mainly described to avoid redundancy.

FIG. 17 illustrates an example of the first area A1_2 included in the display panel PN of FIG. 11.

Referring to FIG. 17, the first area A1_2 of the display panel PN may include a plurality of sub-areas, such as first to third sub-areas AA1_2, AA2_2 and AA3_2 sequentially disposed along the first direction DR1. For example, the second sub-area AA2_2 may be disposed adjacent to the first sub-area AA1_2 along the first direction DR1. Also, the third sub-area AA3_2 may be disposed adjacent to the second sub-area AA2_2 along the first direction DR1. Also, the second sub-area AA2_2 may be disposed between the first sub-area AA1_2 and the third sub-area AA3_2, but is not limited thereto.

Referring to FIG. 11 and FIG. 17, the first and second sub-areas AA1_2 and AA2_2 of the first area A1_2 may be defined as a portion of the first area A1_2 adjacent to the second area A2. Also, the third sub-area AA3_2 may be defined as the other portion of the first area A1_2 except the first and second sub-areas AA1_2 and AA2_2. Herein, the first and second sub-areas AA1_2 and AA2_2 shown in FIG. 17 are merely an example of a portion of the first area A1_2 adjacent to the second area A2. The portion of the first area A1_2 adjacent to the second area A2 may be set variously depending on the design of the display panel PN.

Each of the first to third sub-areas AA1_2 to AA3_2 may include a plurality of pixels disposed to be spaced apart from each other along the first direction DR1 and the second direction DR2.

The first to third sub-areas AA1_2 to AA3_2 may have different densities of second pixels PX2. That is, the second pixels PX2 may be disposed at different densities in the first to third sub-areas AA1_2 to AA3_2.

The proportion of second pixels PX2 per unit area may gradually decrease in the first direction DR1 within the first area A1_2. For example, the proportion of second pixels PX2 per unit area may gradually decrease in a direction from the first sub-area AA1_2 to the third sub-area AA3_2, i.e., with distance from a boundary between the first area A1_2 and the second area A2 within the first area A1_2.

For example, a plurality of first pixels PX1 and a plurality of second pixels PX2 may be disposed in the first sub-area AA1_2, and the plurality of second pixels PX2 may be disposed at the first pixel density in the first sub-area AA1_2.

Also, a plurality of first pixels PX1 and a plurality of second pixels PX2 may be disposed in the second sub-area AA2_2. Further, the plurality of second pixels PX2 may be disposed in the second sub-area AA2_2 at the second pixel density lower than the first pixel density in the first sub-area AA1_2.

Furthermore, only a plurality of first pixels PX1 may be disposed in the third sub-area AA3_2. In other words, any second pixel PX2 is not disposed in the third sub-area AA3_2. Therefore, the third pixel density of second pixels PX2 in the third sub-area AA3_2 may be zero (0).

The first sub-area AA1_2 of the first area A1_2 may include a plurality of columns. Also, the first sub-area AA1_2 of the first area A1_2 may include a plurality of second pixels PX2 sequentially disposed along the second direction DR2 in in one column, and a plurality of first pixels PX1 sequentially disposed along the second direction DR2 in the remaining columns other than the one column. More specifically, referring to FIG. 17, the first sub-area AA1_2 of the first area A1_2 may include the plurality of first pixels PX1 sequentially disposed along the second direction DR2 in each of the first column C1, the second column C2, and the third column C3. Also, the first sub-area AA1_2 of the first area A1_2 may include the plurality of second pixels PX2 sequentially disposed along the second direction DR2 in the fourth column C4. As such, the plurality of second pixels PX2 may be disposed in the fourth column C4, which is one of the four columns C1, C2, C3 and C4, and the plurality of first pixels PX1 may be disposed in the other three columns C1, C2 and C3. In this case, the plurality of second pixels PX2 may be defined as being disposed at the first pixel density in the first sub-area AA1_2.

Further, the second sub-area AA2_2 of the first area A1_2 may include a plurality of columns. Also, the second sub-area AA2_2 of the first area A1_2 may include a plurality of second pixels PX2 sequentially disposed along the second direction DR2 in in one column, and a plurality of first pixels PX1 sequentially disposed along the second direction DR2 in the remaining columns other than the one column. The number of columns in the first sub-area AA1_2 is less than the number of columns in the second sub-area AA2_2. the second sub-area AA2_2 of the first area A1_2 may include the plurality of first pixels PX1 sequentially disposed along the second direction DR2 in each of the fifth column C5, the sixth column C6, the seventh column C7, the eighth column C8, the ninth column C9, and the tenth column C10. Furthermore, the second sub-area AA2_2 of the first area A1_2 may include the plurality of second pixels PX2 sequentially disposed along the second direction DR2 in the eleventh column C11 adjacent to the tenth column C10 in the second direction DR2. As such, the plurality of second pixels PX2 may be disposed in the eleventh column C11, which is one of the seven columns C5, C6, C7, C8, C9, C10 and C11, and the plurality of first pixels PX1 may be disposed in the other six columns C5, C6, C7, C8, C9 and C10. In this case, the plurality of second pixels PX2 may be defined as being disposed at the second pixel density in the second sub-area AA2_2. Herein, as described above, the second pixel density in the second sub-area AA2_2 may be lower than the first pixel density in the first sub-area AA1_2.

Also, only a plurality of first pixels PX1 may be disposed in the third sub-area AA3_2 of the first area A1_2 except the first and second sub-areas AA1_2 and AA2_2 in which the second pixels PX2 are disposed. For example, a plurality of first pixels PX1 may be sequentially disposed along the second direction DR2 in a plurality of columns including the twelfth column C12, the thirteenth column C13 and the like in the third sub-area AA3_2. As such, when only the plurality of first pixels PX1 is disposed in the plurality of columns, the second pixels PX2 may be defined as being disposed at the third pixel density in the third sub-area AA3_2. For example, the third pixel density in the third sub-area AA3_2 may be lower than the second pixel density in the second sub-area AA2_2 which is lower than the first pixel density in the first sub-area AA1_2, and the third pixel density may have a value of substantially zero (0), but is not limited thereto.

Meanwhile, when the display device 100 is driven in the first mode or the second mode, each of the plurality of first pixels PX1 and the plurality of second pixels PX2 disposed in the first area A1_2 of the display panel PN may be driven in the first state or the third state.

For example, as described above with reference to FIG. 14, when each of the plurality of first pixels PX1 and the plurality of second pixels PX2 disposed in the first area A1_2 is driven in the first state, the first light emitting diode ED1 included in each of the plurality of first pixels PX1 disposed in the first area A1_2 emits light. Thus, content may be supplied at the first viewing angle. Also, the third light emitting diode ED3 included in each of the plurality of second pixels PX2 emits light. Thus, content may be supplied at the first viewing angle.

Also, as described above with reference to FIG. 15, when each of the plurality of first pixels PX1 and the plurality of second pixels PX2 disposed in the first area A1_2 is driven in the third state, both of the first light emitting diode ED1 and the second light emitting diode ED2 included in each of the plurality of first pixels PX1 disposed in the first area A1_2 emit light. Thus, content may be supplied at the first viewing angle. Further, both of the third light emitting diode ED3 and the fourth light emitting diode ED4 included in each of the plurality of second pixels PX2 emit light. Thus, content may be supplied at the first viewing angle.

When the display device 100 is driven in the first mode or the second mode, each of the plurality of first pixels PX1 and the plurality of second pixels PX2 disposed in the first area A1_2 of the display panel PN may be driven in the first state or the third state and content may be supplied at the first viewing angle in the first area A1_2. This driving method is substantially the same or similar to the driving method by which each of the plurality of first pixels PX1 and the plurality of second pixels PX2 disposed in the first area A1 is driven in the first state or the third state and content is supplied at the first viewing angle in the first area A1, as described above with reference to FIG. 14 and FIG. 15. Therefore, redundant description thereof will be omitted or briefly provided.

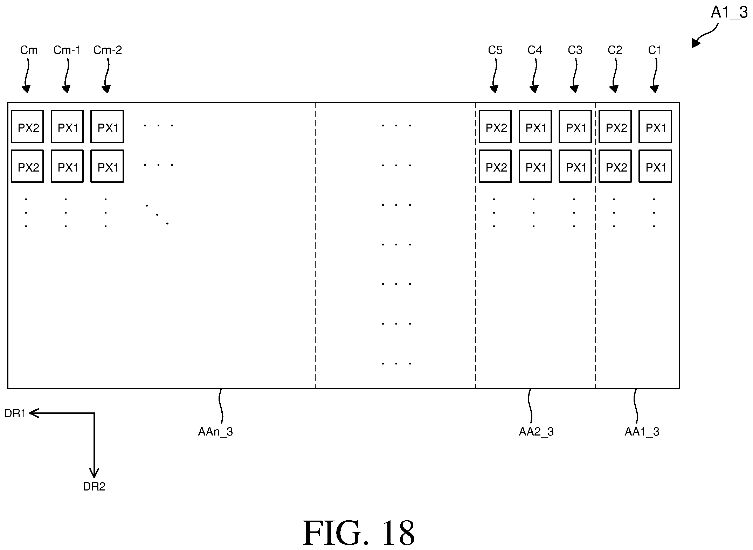

FIG. 18 illustrates still another example of a first area of the display panel of FIG. 11.

FIG. 18 illustrates a modification example of the exemplary embodiment of FIG. 12 in association with the disposition of second pixels PX disposed in a first area A1_3. Therefore, in FIG. 18, portions different from those of the above-described exemplary embodiments will be mainly described to avoid redundancy.

FIG. 18 illustrates an example of the first area A1_3 included in the display panel PN of FIG. 11.

Referring to FIG. 18, the first area A1_3 of the display panel PN may include first to nth sub-areas AA1_3 to AAn_3 (n is an integer greater than 0) sequentially disposed along the first direction DR1. For example, the second sub-area AA2_3 may be disposed adjacent to the first sub-area AA1_3 along the first direction DR1. Also, the first and second sub-areas AA1_3 and AA2_3 of the first area A1_3 may be defined as a portion of the first area A1_3 adjacent to the second area A2, and the nth sub-area Aan_3 may be defined as a sub-area of the first area A1_3 farthest from the second area A2.

A plurality of second pixels PX2 as well as a plurality of first pixels PX1 may be disposed in the entire first area A1_3. For example, each of the first to nth sub-areas AA1_3 to AAn_3 may include the plurality of first pixels PX1 and the plurality of second pixels PX2. For example, each of the first to nth sub-areas AA1_3 to AAn_3 may include the plurality of first pixels PX1 and the plurality of second pixels PX2 disposed to be spaced apart from each other along the first direction DR1 and the second direction DR2.

The first to nth sub-areas AA1_3 to AAn_3 may have different densities of second pixels PX2. That is, the second pixels PX2 may be disposed at different densities in the first to nth sub-areas AA1_3 to AAn_3.

The proportion of second pixels PX2 per unit area may gradually decrease in the first direction DR1 within the first area A1_3. For example, the proportion of second pixels PX2 per unit area may gradually decrease in a direction from the first sub-area AA1_3 to the nth sub-area AAn_3, i.e., with distance from a boundary between the first area A1_3 and the second area A2 within the first area A1_3.

For example, a plurality of first pixels PX1 and a plurality of second pixels PX2 may be disposed in the first sub-area AA1_3, and the plurality of second pixels PX2 may be disposed at the first pixel density in the first sub-area AA1_3. Herein, the first pixel density of a plurality of second pixels PX2 in the first sub-area AA1_3 may be substantially the same or similar to the first pixel density of a plurality of second pixels PX2 in the first sub-area AA1 of the first area A1 described above with reference to FIG. 12. Therefore, redundant description thereof will be omitted or briefly provided.

Also, a plurality of first pixels PX1 and a plurality of second pixels PX2 may be disposed in the second sub-area AA2_3. Further, the plurality of second pixels PX2 may be disposed in the second sub-area AA2_3 at the second pixel density lower than the first pixel density. Herein, the second pixel density of a plurality of second pixels PX2 in the second sub-area AA2_3 may be substantially the same or similar to the second pixel density of a plurality of second pixels PX2 in the second sub-area AA2 of the first area A1 described above with reference to FIG. 12. Therefore, redundant description thereof will be omitted or briefly provided.

Also, a plurality of first pixels PX1 and a plurality of second pixels PX2 may be disposed in the nth sub-area AAn_3. Further, the plurality of second pixels PX2 may be disposed in the nth sub-area AAn_3 at the fourth pixel density lower than the second pixel density.

The nth sub-area AAn_3 of the first area A1_3 may include a plurality of columns. Also, the nth sub-area AAn_3 of the first area A1_3 may include a plurality of second pixels PX2 sequentially disposed along the second direction DR2 in one column, and a plurality of first pixels PX1 sequentially disposed along the second direction DR2 in the remaining columns other than the one column. More specifically, the nth sub-area AAn_3 of the first area A1_3 may include the plurality of first pixels PX1 sequentially disposed along the second direction DR2 in a plurality of columns including an (m-2)th column Cm-2 (m is an integer greater than 0) and an (m-1)th column Cm-1 adjacent to the(m-2)th column Cm-2 in the first direction DR1 and excluding an mth column Cm adjacent to the (m-1)th column Cm-1 in the first direction DR1 in the nth sub-area AAn_3. Also, the nth sub-area AAn_3 may include the plurality of second pixels PX2 sequentially disposed along the second direction DR2 in the mth column. As such, the plurality of second pixels PX2 may be disposed in one Cm of the plurality of columns Cm-2, Cm-1 and Cm and the plurality of first pixels PX1 may be disposed in the other columns Cm-2 and Cm-1. In this case, the plurality of second pixels PX2 may be defined as being disposed at the fourth pixel density in the nth sub-area AAn_3. Herein, as described above, the fourth pixel density may be lower than the second pixel density which is lower than the first pixel density.

As such, the second pixels PX2 may be disposed in the entire first area A1_3 included in the display panel PN of the display device 100 according to the embodiment shown in FIG. 18.

Meanwhile, when the display device 100 is driven in the first mode or the second mode, each of the plurality of first pixels PX1 and the plurality of second pixels PX2 disposed in the first area A1_3 of the display panel PN may be driven in the first state or the third state.

For example, as described above with reference to FIG. 14, when each of the plurality of first pixels PX1 and the plurality of second pixels PX2 disposed in the first area A1_3 is driven in the first state, the first light emitting diode ED1 included in each of the plurality of first pixels PX1 disposed in the first area A1_3 emits light. Thus, content may be supplied at the first viewing angle. Also, the third light emitting diode ED3 included in each of the plurality of second pixels PX2 emits light. Thus, content may be supplied at the first viewing angle.

Also, as described above with reference to FIG. 15, when each of the plurality of first pixels PX1 and the plurality of second pixels PX2 disposed in the first area A1_3 is driven in the third state, both of the first light emitting diode ED1 and the second light emitting diode ED2 included in each of the plurality of first pixels PX1 disposed in the first area A1_3 emit light. Thus, content may be supplied at the first viewing angle. Further, both of the third light emitting diode ED3 and the fourth light emitting diode ED4 included in each of the plurality of second pixels PX2 emit light. Thus, content may be supplied at the first viewing angle.

When the display device 100 is driven in the first mode or the second mode, each of the plurality of first pixels PX1 and the plurality of second pixels PX2 disposed in the first area A1_3 of the display panel PN may be driven in the first state or the third state and content may be supplied at the first viewing angle in the first area A1_1. This driving method is substantially the same or similar to the driving method by which each of the plurality of first pixels PX1 and the plurality of second pixels PX2 disposed in the first area A1 is driven in the first state or the third state and content is supplied at the first viewing angle in the first area A1, as described above with reference to FIG. 14 and FIG. 15. Therefore, redundant description thereof will be omitted or briefly provided.

As in the display device 100 according to an exemplary embodiment of the present disclosure, the first pixel PX1 including only the first type lens 161 which refracts light at the first viewing angle is disposed in the first area A1 which supplies content at the first viewing angle. Also, the second pixel PX2 having the same lens structure as the third pixel PX3 disposed in the second area A2, i.e., including the first type lens 161 and the second type lens 162 which refracts light at the second viewing angle is disposed in the first area A1. Therefore, it is possible to reduce or minimize visibility of the boundary between the first area A1 and the second area A2.

Further, when each of the first pixel PX1 and the second pixel PX2 is driven in the third state compared to the first state in which only the light emitting diodes ED1 and ED2 included in the first pixel PX1 and the light emitting diodes ED3 and ED4 included in the second pixel PX2 emits light in the first area A1 which supplies content at the first viewing angle, content may be supplied at the first viewing angle as in the first state. However, all of the light emitting diodes emit light, and, thus, a luminance of the content may be increased. That is, when the same data signal is written and the first area A1 is driven in the third state, a luminance may be higher compared to the case where the first area A1 is driven in the first state. Therefore, it is possible to reduce or minimize power consumption for increasing a luminance.

A display device according to the exemplary embodiments of the present disclosure can also be described as follows:
A display device according to an exemplary embodiment of the present disclosure includes a display panel divided into a first area including a plurality of first pixels and a plurality of second pixels, and a second area including a plurality of third pixels adjacent to the first area in a direction opposite to a first direction, wherein each of the plurality of first pixels includes a first light emitting diode, a second light emitting diode, a first optical member which emits light generated from the first light emitting diode at a first viewing angle, and a second optical member which emits light generated from the second light emitting diode at the first viewing angle, and each of the plurality of second pixels includes a third light emitting diode, a fourth light emitting diode, a third optical member which emits light generated from the third light emitting diode at the first viewing angle, and a fourth optical member which emits light generated from the fourth light emitting diode at a second viewing angle lower than the first viewing angle, and each of the plurality of third pixels includes a fifth light emitting diode, a sixth light emitting diode, a fifth optical member which emits light generated from the fifth light emitting diode at the first viewing angle, and a sixth optical member which emits light generated from the sixth light emitting diode at the second viewing angle. In one or more embodiments, the plurality of second pixels may be disposed at different pixel densities in respective regions of the first area.

In one or more embodiments, the plurality of first pixels and the plurality of second pixels may be disposed in at least a portion of the first area, and only the plurality of first pixels may be disposed in the other portion of the first area.

In one or more embodiments, the first area may include a first sub-area adjacent to the second area in the first direction, a second sub-area adjacent to the first sub-area in the first direction, and a third sub-area adjacent to the second sub-area in the first direction, and the plurality of second pixels may be disposed at different pixel densities in the first to third sub-areas, respectively.

In one or more embodiments, the pixel density of the plurality of second pixels may gradually decrease in a direction from the first sub-area to the third sub-area.

In one or more embodiments, the plurality of second pixels may be disposed at a first pixel density in the first sub-area, and the plurality of second pixels may be disposed in the second sub-area at a second pixel density lower than the first pixel density.

In one or more embodiments, the plurality of second pixels may be disposed in the third sub-area at a third pixel density lower than the second pixel density.

In one or more embodiments, the third pixel density may have a value of zero (0).

In one or more embodiments, in the first sub-area, the plurality of first pixels may be sequentially disposed in a first column in a second direction different from the first direction, and the plurality of second pixels may be sequentially disposed in the second direction in a second column adjacent to the first column in the first direction, and in the second sub-area, the plurality of first pixels may be sequentially disposed in the second direction in each of a third column adjacent to the second column in the first direction and a fourth column adjacent to the third column in the first direction, and the plurality of second pixels may be sequentially disposed in the second direction in a fifth column adjacent to the fourth column in the first direction.

In one or more embodiments, in the third sub-area, the plurality of first pixels may be sequentially disposed in the second direction in each of a sixth column adjacent to the fifth column in the first direction, a seventh column adjacent to the sixth column in the first direction, an eighth column adjacent to the seventh column in the first direction, a ninth column adjacent to the eighth column in the first direction, a tenth column adjacent to the ninth column in the first direction, an eleventh column adjacent to the tenth column in the first direction, a twelfth column adjacent to the eleventh column in the first direction, and a thirteenth column adjacent to the twelfth column in the first direction.

In one or more embodiments, in the first sub-area, the plurality of first pixels may be sequentially disposed in a second direction different from the first direction in each of a first column and a second column adjacent to the first column in the first direction, and the plurality of second pixels may be sequentially disposed in the second direction in a third column adjacent to the second column in the first direction, and in the second sub-area, the plurality of first pixels may be sequentially disposed in the second direction in each of a fourth column adjacent to the third column in the first direction, a fifth column adjacent to the fourth column in the first direction, a sixth column adjacent to the fifth column in the first direction and a seventh column adjacent to the sixth column in the first direction, and the plurality of second pixels may be sequentially disposed in the second direction in an eighth column adjacent to the seventh column in the first direction.

In one or more embodiments, in the third sub-area, the plurality of first pixels may be sequentially disposed in the second direction in each of a ninth column adj acent to the eighth column in the first direction, a tenth column adjacent to the ninth column in the first direction, an eleventh column adjacent to the tenth column in the first direction, a twelfth column adjacent to the eleventh column in the first direction, and a thirteenth column adjacent to the twelfth column in the first direction.

In one or more embodiments, in the first sub-area, the plurality of first pixels may be sequentially disposed in a second direction different from the first direction in each of a first column, a second column adjacent to the first column in the first direction and a third column adjacent to the second column in the first direction, and the plurality of second pixels may be sequentially disposed in the second direction in a fourth column adjacent to the third column in the first direction, and in the second sub-area, the plurality of first pixels may be sequentially disposed in the second direction in each of a fifth column adjacent to the fourth column in the first direction, a sixth column adj acent to the fifth column in the first direction, a seventh column adjacent to the sixth column in the first direction, an eighth column adjacent to the seventh column in the first direction, a ninth column adjacent to the eighth column direction and a tenth column adjacent to the ninth column in the first direction, and the plurality of second pixels may be sequentially disposed in the second direction in an eleventh column adjacent to the tenth column in the first direction.

In one or more embodiments, in the third sub-area, the plurality of first pixels may be sequentially disposed in the second direction in each of a twelfth column adjacent to the eleventh column in the first direction, and a thirteenth column adjacent to the twelfth column in the first direction.

In one or more embodiments, only the plurality of first pixels may be disposed in the third sub-area.

In one or more embodiments, the plurality of first pixels and the plurality of second pixels may be disposed in the entire first area.

In one or more embodiments, the first area may include first to nth sub-areas (n is an integer greater than 0) sequentially disposed along the first direction from the second area, and the plurality of second pixels may be disposed at different pixel densities in the first to nth sub-areas, respectively.

In one or more embodiments, the pixel density of the plurality of second pixels may gradually decrease in a direction from the first sub-area to the nth sub-area.

In one or more embodiments, the first light emitting diode included in each of the plurality of first pixels of the first area may emit light, and the second light emitting diode included in each of the plurality of first pixels may not emit light, and the third light emitting diode included in each of the plurality of second pixels of the first area may emit light, and the fourth light emitting diode included in each of the plurality of second pixels may not emit light.

In one or more embodiments, each of the first light emitting diode and the second light emitting diode included in each of the plurality of first pixels of the first area may emit light, and each of the third light emitting diode and the fourth light emitting diode included in each of the plurality of second pixels of the first area may emit light.

In one or more embodiments, in a first mode, the fifth light emitting diode included in each of the plurality of third pixels of the second area may emit light and the sixth light emitting diode included in each of the plurality of third pixels may not emit light, and in a second mode different from the first mode, the fifth light emitting diode included in each of the plurality of third pixels of the second area may not emit light and the sixth light emitting diode included in each of the plurality of third pixels may emit light.

In one or more embodiments, each of the first optical member, the second optical member, the third optical member, and the fifth optical member may have a first shape, and each of the fourth optical member and the sixth optical member may have a second shape different from the first shape.

In one or more embodiments, the first light emitting diode may emit light of the same color as that emitted by the second light emitting diode, the third light emitting diode may emit light of the same color as that emitted by the fourth light emitting diode, and the fifth light emitting diode may emit light of the same color as that emitted by the sixth light emitting diode.

A display device according to one or more exemplary embodiments of the present disclosure may be applied to mobile apparatuses, video phones, smart watches, watch phones, wearable apparatuses, foldable apparatuses, rollable apparatuses, bendable apparatuses, flexible apparatuses, curved apparatuses, variable apparatuses, sliding apparatuses, electronic organizers, electronic books, portable multimedia players (PMPs), personal digital assistants (PDAs), MP3 players, mobile medical devices, desktop personal computers (PCs), laptop PCs, netbook computers, workstations, navigation apparatuses, automotive navigation apparatuses, automotive display apparatuses, automotive apparatuses, theater apparatuses, theater display apparatuses, TVs, wall paper display apparatuses, signage apparatuses, game machines, notebook computers, monitors, cameras, camcorders, home appliances, etc., but embodiments of the present disclosure are not limited thereto.

Although the exemplary embodiments of the present disclosure have been described in detail with reference to the accompanying drawings, the present disclosure is not limited thereto and may be embodied in many different forms without departing from the technical concept of the present disclosure. Therefore, the exemplary embodiments of the present disclosure are provided for illustrative purposes only but not intended to limit the technical concept of the present disclosure. The scope of the technical concept of the present disclosure is not limited thereto. Therefore, it should be understood that the above-described exemplary embodiments are illustrative in all aspects and do not limit the present disclosure. The protective scope of the present disclosure should be construed based on the following claims.

## Claims

1. A display device (100), comprising:
a display panel (PN) divided into a first area (A1, A1_1, A1_2, A1_3) including a plurality of first pixels (PX1) and a plurality of second pixels (PX2), and a second area (A2) including a plurality of third pixels (PX3) adjacent to the first area (A1, A1_1, A1_2, A1_3) in a direction opposite to a first direction (DR1),
wherein each of the plurality of first pixels (PX1) includes a first light emitting diode (ED1), a second light emitting diode (ED2), a first optical member which emits light generated from the first light emitting diode (ED1) at a first viewing angle, and a second optical member which emits light generated from the second light emitting diode (ED2) at the first viewing angle, and
each of the plurality of second pixels (PX2) includes a third light emitting diode (ED3), a fourth light emitting diode (ED4), a third optical member which emits light generated from the third light emitting diode (ED3) at the first viewing angle, and a fourth optical member which emits light generated from the fourth light emitting diode (ED4) at a second viewing angle lower than the first viewing angle, and
each of the plurality of third pixels (PX3) includes a fifth light emitting diode (ED5), a sixth light emitting diode (ED6), a fifth optical member which emits light generated from the fifth light emitting diode (ED5) at the first viewing angle, and a sixth optical member which emits light generated from the sixth light emitting diode (ED6) at the second viewing angle.

2. The display device (100) according to claim 1, wherein the plurality of second pixels (PX2) is disposed at different pixel densities in respective regions of the first area (A1, A1_1, A1_2, A1_3).

3. The display device (100) according to claim 2, wherein the plurality of first pixels (PX1) and the plurality of second pixels (PX2) are disposed in at least a portion of the first area (A1, A1_1, A1_2, A1_3), and only the plurality of first pixels (PX1) is disposed in the other portion of the first area (A1, A1_1, A1_2, A1_3).

4. The display device (100) according to claim 3, wherein the first area (A1, A1_1, A1_2, A1_3) includes a first sub-area (AA1, AA1_1, AA1_2, AA1_3) adjacent to the second area (A2) in the first direction (DR1), a second sub-area (AA2, AA2_1, AA2_2, AA2_3) adjacent to the first sub-area (AA1, AA1_1, AA1_2, AA1_3) in the first direction (DR1), and a third sub-area (AA3, AA3_1, AA3_2) adj acent to the second sub-area (AA2, AA2_1, AA2_2, AA2_3) in the first direction (DR1), and
the plurality of second pixels (PX2) is disposed at different pixel densities in the first to third sub-areas (AA1, AA1_1, AA1_2, AA1_3; AA2, AA2_1, AA2_2, AA2_3; AA3, AA3_1, AA3_2), respectively.

5. The display device (100) according to claim 4, wherein the pixel density of the plurality of second pixels (PX2) gradually decreases in a direction from the first sub-area (AA1, AA1_1, AA1_2, AA1_3) to the third sub-area (AA3, AA3_1, AA3_2),
wherein, preferably, the plurality of second pixels (PX2) is disposed at a first pixel density in the first sub-area (AA1, AA1_1, AA1_2, AA1_3), and
the plurality of second pixels (PX2) is disposed in the second sub-area (AA2, AA2_1, AA2_2, AA2_3) at a second pixel density lower than the first pixel density,
wherein, further preferably, the plurality of second pixels (PX2) is disposed in the third sub-area (AA3, AA3_1, AA3_2) at a third pixel density lower than the second pixel density,
wherein, still further preferably, the third pixel density has a value of zero.

6. The display device (100) according to claim 4 or 5, wherein in the first sub-area (AA1), the plurality of first pixels (PX1) is sequentially disposed in a first column (C1) in a second direction (DR2) different from the first direction (DR1), and the plurality of second pixels (PX2) is sequentially disposed in the second direction (DR2) in a second column (C2) adjacent to the first column (C1) in the first direction (DR1), and
in the second sub-area (AA2), the plurality of first pixels (PX1) is sequentially disposed in the second direction (DR2) in each of a third column (C3) adjacent to the second column in the first direction (DR1) and a fourth column (C4) adjacent to the third column (C3) in the first direction (DR1), and the plurality of second pixels (PX2) is sequentially disposed in the second direction (DR2) in a fifth column (C5) adjacent to the fourth column (C4) in the first direction (DR1),
wherein, preferably:
in the third sub-area (AA3), the plurality of first pixels (PX1) is sequentially disposed in the second direction (DR2) in each of a sixth column (C6) adjacent to the fifth column in the first direction (DR1), a seventh column (C7) adjacent to the sixth column (C6) in the first direction (DR1), an eighth column (C8) adjacent to the seventh column (C7) in the first direction (DR1), a ninth column (C9) adjacent to the eighth column (C8) in the first direction (DR1), a tenth column (C10) adjacent to the ninth column (C9) in the first direction (DR1), an eleventh column (C11) adj acent to the tenth column (C10) in the first direction (DR1), a twelfth column (C12) adjacent to the eleventh column (C11) in the first direction (DR1), and a thirteenth column (C13) adjacent to the twelfth column (C12) in the first direction (DR1).

7. The display device (100) according to claim 4 or 5, wherein in the first sub-area (AA1_1), the plurality of first pixels (PX1) is sequentially disposed in a second direction (DR2) different from the first direction (DR1) in each of a first column (C1) and a second column (C2) adjacent to the first column (C1) in the first direction (DR1), and the plurality of second pixels (PX2) is sequentially disposed in the second direction (DR2) in a third column (C3) adjacent to the second column (C2) in the first direction (DR1), and
in the second sub-area (AA2_1), the plurality of first pixels (PX1) is sequentially disposed in the second direction (DR2) in each of a fourth column (C4) adjacent to the third column (C3) in the first direction (DR1), a fifth column (C5) adjacent to the fourth column (C4) in the first direction (DR1), a sixth column (C6) adjacent to the fifth column (C5) in the first direction (DR1) and a seventh column (C7) adjacent to the sixth column (C6) in the first direction (DR1), and the plurality of second pixels (PX2) is sequentially disposed in the second direction (DR2) in an eighth column (C8) adjacent to the seventh column (C7) in the first direction (DR1),
wherein, preferably:
in the third sub-area (AA3_1), the plurality of first pixels (PX1) is sequentially disposed in the second direction (DR2) in each of a ninth column (C9) adjacent to the eighth column (C8) in the first direction (DR1), a tenth column (C10) adjacent to the ninth column (C9) in the first direction (DR1), an eleventh column (C11) adjacent to the tenth column (C10) in the first direction (DR1), a twelfth column (C12) adjacent to the eleventh column (C11) in the first direction (DR1), and a thirteenth column (C13) adjacent to the twelfth column (C12) in the first direction (DR1).

8. The display device (100) according to claim 4 or 5, wherein in the first sub-area (AA1_2), the plurality of first pixels (PX1) is sequentially disposed in a second direction (DR2) different from the first direction (DR1) in each of a first column (C1), a second column (C2) adjacent to the first column (C1) in the first direction (DR1) and a third column (C3) adjacent to the second column (C2) in the first direction (DR1), and the plurality of second pixels (PX2) is sequentially disposed in the second direction (DR2) in a fourth column (C4) adjacent to the third column (C3) in the first direction (DR1), and
in the second sub-area (AA2_2), the plurality of first pixels (PX1) is sequentially disposed in the second direction (DR2) in each of a fifth column (C5) adjacent to the fourth column (C4) in the first direction (DR1), a sixth column (C6) adjacent to the fifth column (C5) in the first direction (DR1), a seventh column (C7) adjacent to the sixth column (C6) in the first direction (DR1), an eighth column (C8) adjacent to the seventh column (C7) in the first direction (DR1), a ninth column (C9) adjacent to the eighth column direction (C8) and a tenth column (C10) adjacent to the ninth column (C9) in the first direction (DR1), and the plurality of second pixels (PX2) is sequentially disposed in the second direction (DR2) in an eleventh column (C11) adjacent to the tenth column (C10) in the first direction (DR1).

9. The display device (100) according to claim 8, wherein in the third sub-area (AA3_2), the plurality of first pixels (PX1) is sequentially disposed in the second direction (DR2) in each of a twelfth column (C12) adjacent to the eleventh column (C11) in the first direction (DR1), and a thirteenth column (C13) adjacent to the twelfth column (C12) in the first direction (DR1),
wherein, preferably, only the plurality of first pixels (PX1) is disposed in the third sub-area (AA3_2).

10. The display device (100) according to claim 2, wherein the plurality of first pixels (PX1) and the plurality of second pixels (PX2) are disposed in the entire first area (A1_3).

11. The display device (100) according to claim 10, wherein the first area (A1_3) includes first to nth sub-areas (AA1_3, AA2_3, ..., AAn_3) sequentially disposed along the first direction (DR1) from the second area (A2), and
the plurality of second pixels (PX2) is disposed at different pixel densities in the first to nth sub-areas (AA1_3, AA2_3, ..., AAn_3), respectively, wherein n is an integer greater than 0,
wherein, preferably, the pixel density of the plurality of second pixels (PX2) gradually decreases in a direction from the first sub-area (AA1_3) to the nth sub-area (AAn_3).

12. The display device (100) according to any of claims 2 to 11, wherein:
the first light emitting diode (ED1) included in each of the plurality of first pixels (PX1) of the first area (A1, A1_1, A1_2, A1_3) emits light, and the second light emitting diode (ED2) included in each of the plurality of first pixels (PX1) does not emit light, and
the third light emitting diode (ED3) included in each of the plurality of second pixels (PX2) of the first area (A1, A1_1, A1_2, A1_3) emits light, and the fourth light emitting diode (ED4) included in each of the plurality of second pixels (PX2) does not emit light;
or wherein:
each of the first light emitting diode (ED1) and the second light emitting diode (ED2) included in each of the plurality of first pixels (PX1) of the first area (A1, A1_1, A1_2, A1_3) emits light, and
each of the third light emitting diode (ED3) and the fourth light emitting diode (ED4) included in each of the plurality of second pixels (PX2) of the first area (A1, A1_1, A1_2, A1_3) emits light.

13. The display device (100) according to any of claims 2 to 12, wherein in a first mode, the fifth light emitting diode (ED5) included in each of the plurality of third pixels (PX3) of the second area (A2) emits light and the sixth light emitting diode (ED6) included in each of the plurality of third pixels (PX3) does not emit light, and
in a second mode different from the first mode, the fifth light emitting diode (ED5) included in each of the plurality of third pixels (PX3) of the second area (A2) does not emit light and the sixth light emitting diode (ED6) included in each of the plurality of third pixels (PX3) emits light.

14. The display device (100) according to any of claims 2 to 13, wherein each of the first optical member, the second optical member, the third optical member, and the fifth optical member has a first shape, and
each of the fourth optical member and the sixth optical member has a second shape different from the first shape.

15. The display device (100) according to any of claims 2 to 14, wherein the first light emitting diode (ED1) emits light of the same color as that emitted by the second light emitting diode (ED2),
the third light emitting diode (ED3) emits light of the same color as that emitted by the fourth light emitting diode (ED4), and
the fifth light emitting diode (ED5) emits light of the same color as that emitted by the sixth light emitting diode (ED6).
